# EUROPÄISCHE PATENTSCHRIFT

(11) **EP 3 103 148 B1**
(45) Veröffentlichungstag und Bekanntmachung des Hinweises auf die Patenterteilung: **11.12.2019**
(21) Anmeldenummer: 15704739.0
(22) Anmeldetag: 04.02.2015
(51) Int. Cl.: H01L 51/54, C09K 11/06

(54) **ORGANISCHE MOLEKÜLE ZUR VERWENDUNG IN OPTOELEKTRONISCHEN BAUELEMENTEN**
ORGANIC MOLECULES FOR USE IN OPTOELECTRONIC COMPONENTS
MOLÉCULES ORGANIQUES DESTINÉES À ÊTRE UTILISÉES DANS DES ÉLÉMENTS DE CONSTRUCTION OPTO-ÉLECTRONIQUES

(30) Priorität: 04.02.2014 EP 14153893; 15.09.2014 EP 14184773
(43) Veröffentlichungstag der Anmeldung: 14.12.2016
(73) Patentinhaber: cynora GmbH, 76646 Bruchsal (DE)
(72) Erfinder: VOLZ, Daniel, 76137 Karlsruhe (DE); DANZ, Michael, 76344 Eggenstein-Leopoldshafen (DE); BAUMANN, Thomas, 76133 Karlsruhe (DE)
(74) Vertreter: Hoppe, Georg Johannes
(86) Internationale Anmeldenummer: PCT/EP2015/052347
(87) Internationale Veröffentlichungsnummer: WO 2015/118035

(56) Entgegenhaltungen:
- JIYOUNG LEE ET AL: "Oxadiazole- and triazole-based highly-efficient thermally activated delayed fluorescence emitters for organic light-emitting diodes", JOURNAL OF MATERIALS CHEMISTRY C, Bd. 1, Nr. 30, 1. Januar 2013 (2013-01-01) , Seite 4599, XP055191745, ISSN: 2050-7526, DOI: 10.1039/c3tc30699b
- ZHANG Q ET AL: "'Click' synthesis of starburst triphenylamine as potential emitting material", DYES AND PIGMENTS, ELSEVIER APPLIED SCIENCE PUBLISHERS. BARKING, GB, Bd. 81, Nr. 1, 1. April 2009 (2009-04-01), Seiten 80-84, XP025672880, ISSN: 0143-7208, DOI: 10.1016/J.DYEPIG.2008.09.005 [gefunden am 2008-09-19]
- FABIAN ZIESCHANG ET AL: "Solvent Controlled Energy Transfer Processes in Triarylamine-Triazole Based Dendrimers", JOURNAL OF PHYSICAL CHEMISTRY C, Bd. 117, Nr. 39, 19. September 2013 (2013-09-19), Seiten 19816-19831, XP055160810, ISSN: 1932-7447, DOI: 10.1021/jp404708x
- CLAUDINE KATAN ET AL: "Position Isomerism on One and Two Photon Absorption in Multibranched Chromophores: A TDDFT Investigation", JOURNAL OF CHEMICAL THEORY AND COMPUTATION, Bd. 6, Nr. 11, 21. Oktober 2010 (2010-10-21), Seiten 3410-3426, XP055160813, ISSN: 1549-9618, DOI: 10.1021/ct1004406

## Beschreibung

Die Erfindung betrifft neue organische Moleküle sowie deren Verwendung in optoelektronischen Bauelementen, insbesondere in organischen lichtemittierenden Dioden (OLEDs).

### Stand der Technik

In den letzten Jahren hat sich die auf OLED (Organic Light Emitting Diodes) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik.

Aus diesem Grund wird bezüglich der Entwicklung neuer Materialien intensive Forschung betrieben. Obwohl eine OLED generell aus mehreren Schichten aufgebaut ist und für all diese ein Bedarf nach optimierten Materialien vorhanden ist, bildet dennoch die Emitterschicht (EML: *emitting layer*) das Kernstück eines solchen Bauteils, welche aus dem eigentlichen Emitter, welcher letztendlich die elektrische Energie in Photonen umwandelt, und optional Wirtsmolekülen (hosts) besteht.

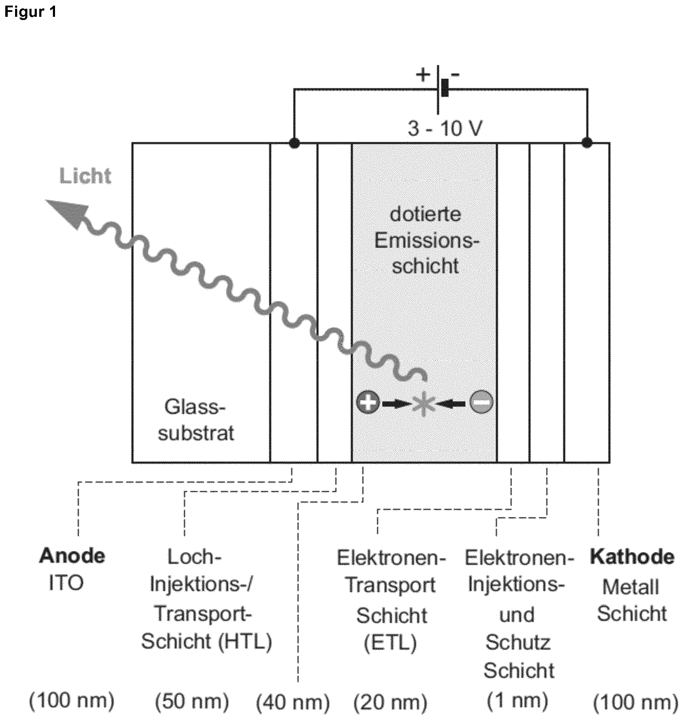

Derartige Bauteile sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass theoretisch alle Exzitonen in Licht umgewandelt werden können. Diese Materialien zeigen jedoch gewisse Nachteile, vor allem bezüglich Kosten und Stabilität der verwendeten Materialien.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422).

In den letzten Dekaden hat eine stetige Weiterentwicklung dieser Emittermaterialen stattgefunden, wobei auch immer wieder neue Konzepte entwickelt wurden, um den hohen Preis und die Seltenheit von Edelmetallen zu umgehen. Angefangen bei rein fluoreszenten organischen Molekülen über Schwermetallkomplexe, insbesondere Iridium und Platin (triplet harvesting), geht die Entwicklung heutzutage in Richtung des Ausnutzens verzögerter Fluoreszenz (TADF: *thermally activated delayed fluorescence* oder auch *singlet harvesting*). Hierbei können beispielsweise Cu(I)-Komplexe verwendet werden, die aufgrund eines geringen ΔE_{ST} Triplett-Exitonen thermisch in einen Singulett-Zustand rückbesetzen können. Neben der Verwendung von Übergangsmetallkomplexen können auch rein organische Moleküle (ohne Metallion) diesen Effekt ausnutzen.

Die intensive Forschung in diesem Bereich zeigt, dass es trotz einiger bereits bestehender Konzepte für derartige Emittermaterialien weiterhin einen großen Bedarf an neuen Materialien gibt. Unter anderem ist hierfür ursächlich, dass es sowohl unterschiedliche Anwendungsbereiche (Bildschirmtechnologie, Beleuchtung, smarte Verpackungen usw.) als auch Herstellungsweisen (Vakuum, Flüssig oder hybride Prozessierungen) gibt. Besonders für den Bereich der Flüssigprozessierung muss ebenso die gezielte Löslichkeit bzw. Unlöslichkeit in speziellen Lösungsmitteln beachtet werden (Orthogonalität), damit Schichten nachfolgend aufgebracht werden können, ohne dass sich die zuvor abgeschiedene Schicht wieder anlöst. Neben den erwähnten Eigenschaften dieser Materialien ist für eine Kommerzialisierung ebenso die Zugänglichkeit relevant. Dies schließt sowohl die Verfügbarkeit von Synthesebausteinen, als auch den Aufwand für die eigentliche Synthese des funktionellen Materials, insbesondere dessen Aufreinigung mit ein.

JIYOUNG LEE et al. offenbart Oxadiazol- und Triazol-basierte thermisch aktivierte verzögerte Fluoreszenzemitter für OLEDs (JOURNAL OF MATERIALS CHEMISTRY C, Vol. 1, Nr. 30, Seite 4599). ZHANG Q et al. beschreibt die Clicksynthese von Triphenylaminen als Emitter (DYES AND PIGMENTS, ELSEVIER APPLIED SCIENCE PUBLISHERS. Vol. 81, Nr. 1, Seite 80 - 84). FABIAN ZIESCHANG et al. offenbart Energietransferprozesse in Triarylamin-Triazol-basierten Dendrimeren (JOURNAL OF PHYSICAL CHEMISTRY C, Vol. 117, Nr. 39, Seite 19816 - 19831). CLAUDINE KATAN et al. beschreibt multiverzeweigte Chromophore (JOURNAL OF CHEMICAL THEORY AND COMPUTATION, Vol. 6, Nr. 11, Seite 3410 - 3426).

### Beschreibung der Erfindung

Allgemein betrifft die Erfindung rein organische Moleküle (Farbstoffe) und deren Verwendung als Emitter in OLEDs (organic light emitting diodes) und in anderen opto-elektronischen Bauelementen.

Die Erfindung betrifft in einem Aspekt organische Moleküle umfassend eine chemische Struktur oder bestehend aus einer chemischen Struktur nach Formel 1 (Farbstoffe, Emitter-Moleküle) 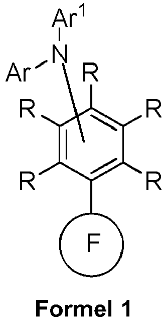 wobei das organische Molekül eine Struktur gemäß der Formel 1* oder Formel 1** aufweist 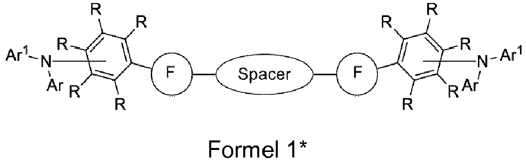 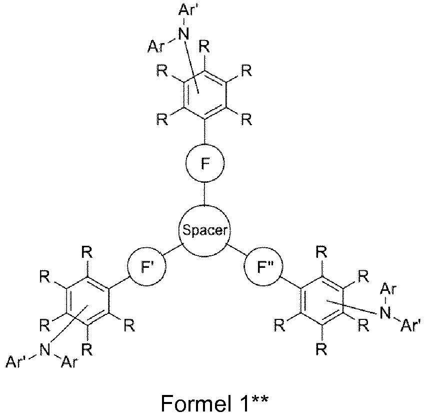 mit F, F' und F" ausgewählt aus der Gruppe bestehend aus 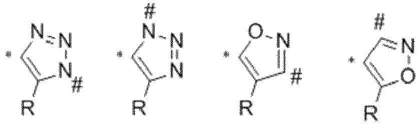 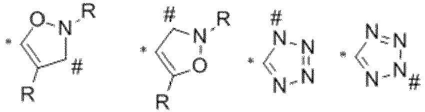 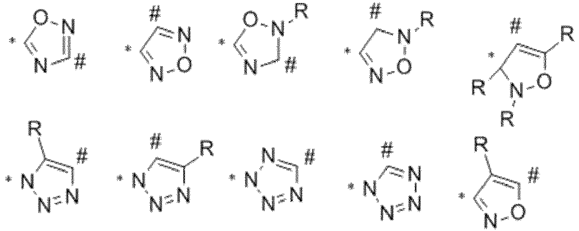 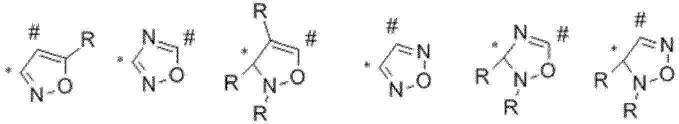
wobei die Verknüpfung zu den benachbarten Einheiten an den mit * und # markierten Stellen stattfindet und wobei
   Spacer ein substituiertes oder unsubstituiertes aromatisches oder heteroaromatisches Ringsystem mit 5 bis 60 aromatischen Ringatomen ist;
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden; R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden; und die Verknüpfung zur Phenyleinheit an der mit * markierten Stelle stattfindet;
NArAr¹ ist ein Donor, der an einer beliebigen Position am Phenylring anstelle eines Rests R gebunden ist (also in ortho-, meta- oder para-Stellung zur F-Einheit, wobei die übrigen Substitutionsstellen des Phenylrings mit R substituiert sind) mit Ar, Ar¹ = unabhängig voneinander ein aromatisches oder heteroaromatisches Ringsystem mit 5 - 60 aromatischen Ringatomen, das jeweils durch einen oder mehrere Reste R substituiert sein kann. Ar und Ar¹ sind über eine Einheit E miteinander verbunden (z. B. Carbazol, Phenoxazin, Phenothiazin); E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist.

Das erfindungsgemäße organische Molekül kann ausgewählt sein aus der folgenden Gruppe:

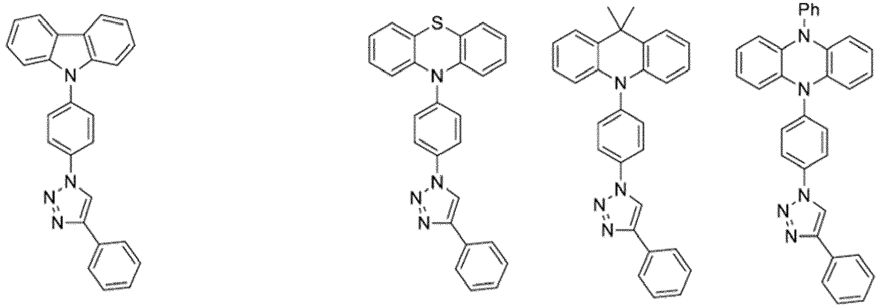

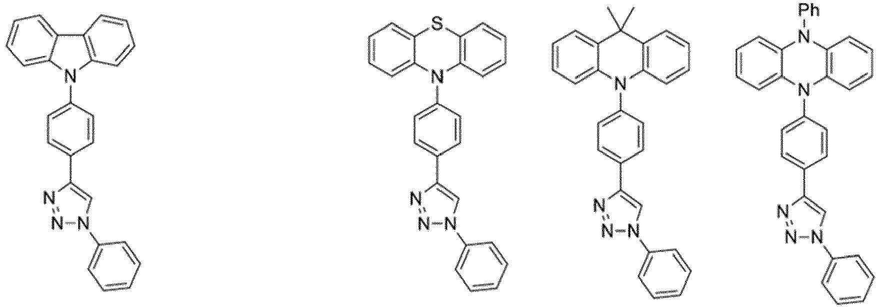

Bei einer [i+j]-Cycloaddition werden jeweils i und j aneinanderhängende Atome der reagierenden Spezies zu einem Ringsystem mit insgesamt i + j Atomen verknüpft.

In einer Ausführungsform sind NArAr¹ und F an nicht benachbarte Atome des Phenylrings gebunden.

Unter einem 1,3-Dipol versteht man ein mindestens dreiatomiges Molekül, das sich durch zwitterionische mesomere Grenzstrukturen beschreiben lässt, wobei jedem der drei Atome, über welche die positive bzw. negative Ladung delokalisiert ist, ein Elektronenoktett zukommt. Als Dipolarophil bezeichnet man das synthetische Gegenüber zu dem 1,3-Dipol. Bei 1,3-Dipolen sind es vier π-Elektronen, bei den Dipolarophilen zwei π-Elektronen, welche am Reaktionsgeschehen im Sinne der Bindungsbildung/Bindungsänderung beteiligt sind.

Beispiele für Dipolarophile sind Alkene, Alkine, aber auch mehrbindige, heteroatomhaltige Gruppen, wie Nitrile und Carbonyle. 1,3-Dipolare Verbindungen enthalten mindestens ein Heteroatom und können mit mindestens einer mesomeren Struktur beschrieben werden, welche zwei Ladungen enthält.

In einer Ausführungsform weist das organische Molekül der Formel 1 eine Struktur der Formel A auf: 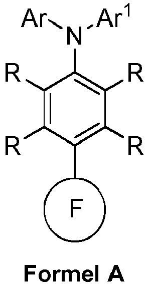 wobei sich die NArAr¹-Einheit und die F-Einheit in para-Position zueinander befinden und im Übrigen die bei Formel 1 angegebenen Definitionen gelten.

In einer erfindungsgemäßen Ausführungsform liegt das organische Molekül der Formel 1 als dimeres System vor, in dem die zwei gleichen oder verschiedenen Ringe F und F' durch einen Spacer verbrückt sind, der ein substituiertes oder unsubstituiertes aromatisches oder heteroaromatisches Ringsystem mit 5 bis 60 aromatischen Ringatomen ist. Es ergibt sich somit ein Dimer der Formel 1*. 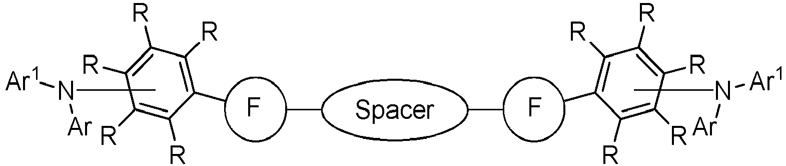 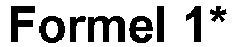 In Formel 1* gilt:
F und F' = unabhängig voneinander ein unsubstituierter oder substituierter 5-gliederiger Ring, der aus einer [i+j]-Cycloaddition aus einem Dipolarophil und einem 1,3-Dipol gebildet werden kann und insbesondere ausgewählt ist aus der Gruppe bestehend aus 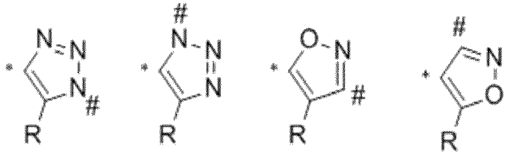 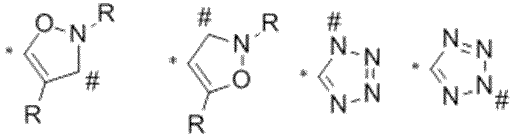 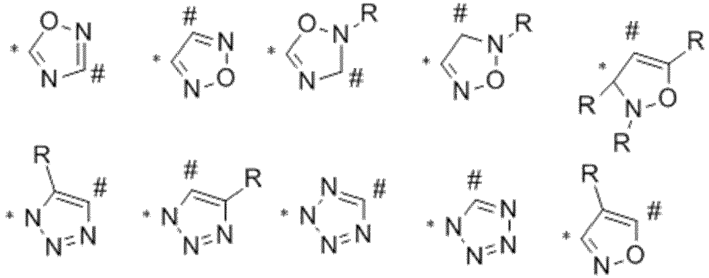 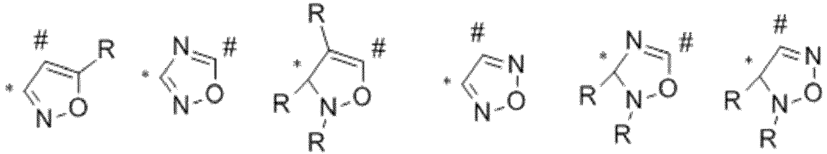 wobei
die Verknüpfung zu den Phenyleinheiten an den mit * und # markierten Stellen stattfindet und Spacer = ein substituiertes oder unsubstituiertes aromatisches oder heteroaromatisches Ringsystem mit 5 bis 60 aromatischen Ringatomen, wobei F und/oder F' in einer Ausführungsform mindestens ein Heteroatom enthält. Im Übrigen gelten die bei Formel 1 angegebenen Definitionen.

In einer Ausführungsform weist das dimere System der Formel 1* eine Struktur der Formel A* auf: 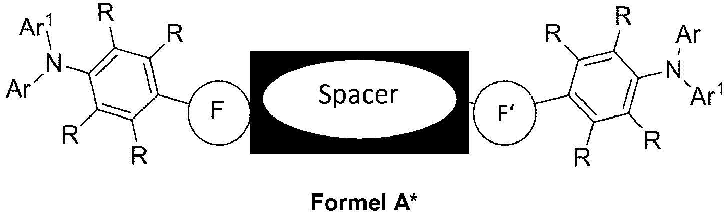 wobei sich die NArAr¹-Einheit in para-Position zu der F-Einheit bzw. der F'-Einheit befindet und im Übrigen die bei Formel 1* angegebenen Definitionen gelten.

In einer Ausführungsform sind die Phenylringe gleich zueinander.

In einer Ausführungsform sind F und F' an nicht benachbarte Atome des Spacers gebunden.

In einer Ausführungsform sind F bzw. F' und NArAr¹ nicht an direkt benachbarten Atomen des jeweiligen Phenylrings gebunden. F und F' können identisch sein.

In einer erfindungsgemäßen Ausführungsform liegt das organische Molekül der Formel 1 als trimeres System der Formel 1** vor, in dem die drei gleichen oder verschiedenen Ringe F, F' und F" durch einen Spacer verbrückt sind, der ein substituiertes oder unsubstituiertes aromatisches oder heteroaromatisches Ringsystem mit 5 bis 60 aromatischen Ringatomen ist, wobei F, F' und F" unabhängig von einander ein unsubstituierter oder substituierter 5-gliederiger Ring ist, der aus einer [i+j]-Cycloaddition aus einem Dipolarophil und einem 1,3-Dipol gebildet werden kann und insbesondere ausgewählt sind aus der Gruppe bestehend aus 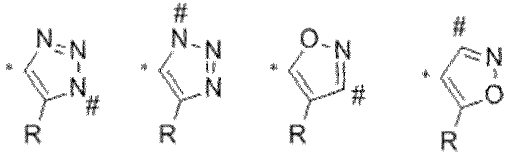 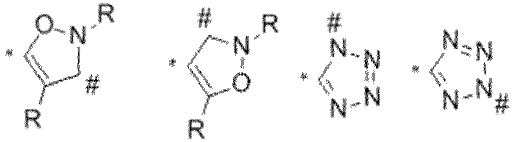 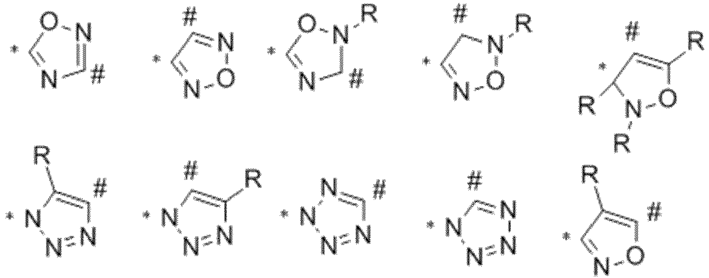 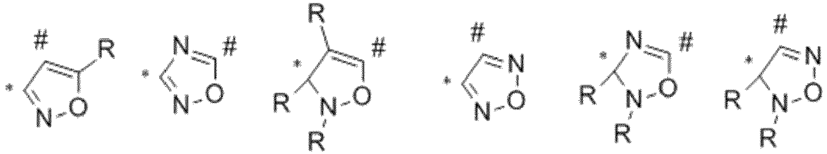 wobei
die Verknüpfung zu den Phenyleinheiten an den mit * und # markierten Stellen stattfindet und Spacer ein substituiertes oder unsubstituiertes aromatisches oder heteroaromatisches Ringsystem mit 5 bis 60 aromatischen Ringatomen ist, wobei F und/oder F' und/oder F" mindestens ein Heteroatom enthält. Im Übrigen gelten die bei Formel 1* angegebenen Definitionen.

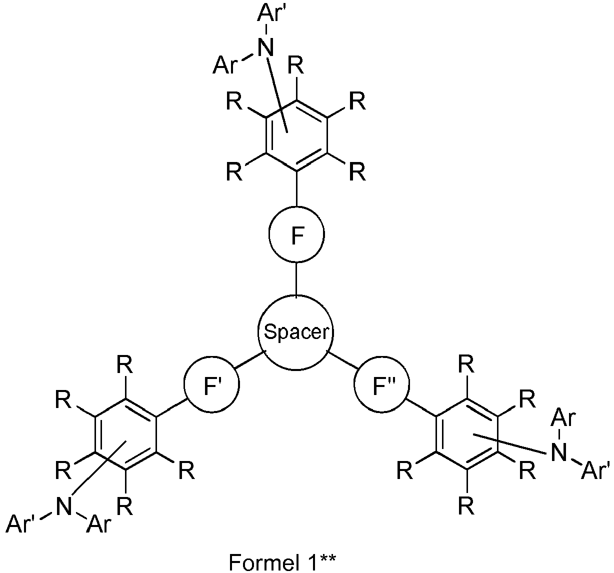

In einer Ausführungsform weist das trimere System der Formel 1** eine Struktur der Formel A** auf: 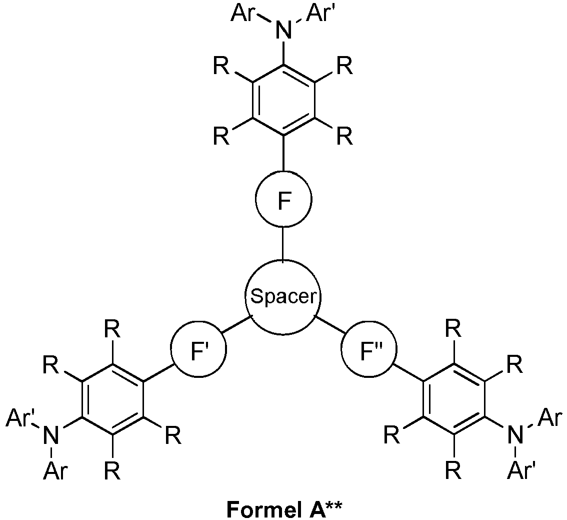 wobei sich die NArAr¹-Einheit und die F-Einheit bzw. die F'-Einheit bzw. die F"-Einheit jeweils in para-Position zueinander befinden und im Übrigen die bei Formel 1* angegebenen Definitionen gelten.

In einer Ausführungsform sind die Phenylringe gleich zueinander.

In einer Ausführungsform sind F und F' und F" an nicht benachbarte Atome des Spacers gebunden.

In einer weiteren Ausführungsform ist F gleich F' gleich F".

Die Beschreibung betrifft auch nicht erfindungsgemäße organische Moleküle gemäß Formel 1', in denen an die Einheit F ein weiterer Phenylring und an diese wiederum eine Einheit NArAr¹ gebunden ist, so dass diese organischen Moleküle eine Struktur der Formel 1' aufweisen.

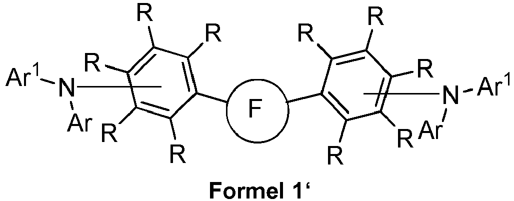

F steht für einen unsubstituierten oder substituierten 5-gliederigen Ring, der in einer Ausführungsform optional mindestens ein Heteroatom aufweist, der aus einer [i+j]-Cycloaddition aus einem Dipolarophil und einem 1,3-Dipol gebildet werden kann, wobei F und NArAr¹ in einer Ausführungsform nicht an direkt benachbarten Atomen des Phenylrings gebunden sind. Im Übrigen gelten die bei Formel 1* angegebenen Definitionen.

In einer nicht erfindungsgemäßen Ausführungsform weist das organische Moleküle gemäß Formel 1' eine Struktur der Formel A' auf: 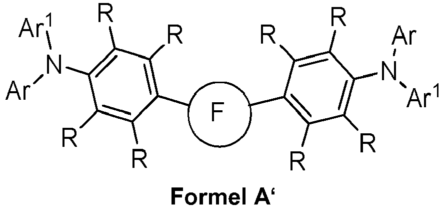 wobei sich die NArAr¹-Einheit und die F-Einheit jeweils in para-Position zueinander befinden und im Übrigen die bei Formel 1* angegebenen Definitionen gelten. Eine Ausführungsform der Erfindung betrifft organischen Moleküle, welche
- einen ΔE(S₁-T₁)-Wert zwischen dem untersten angeregten Singulett (S₁)- und dem darunter liegenden Triplett (T₁)-Zustand von kleiner als 5000 cm⁻¹, insbesonere kleiner als 3000 cm⁻¹ aufweisen und/oder
- eine Emissionslebensdauer von höchstens 50 µs aufweisen.

In einer Ausführungsform weisen der Phenylring, F, F', F" und/oder NArAr¹ mindestens einen Substituenten zur Erhöhung der Löslichkeit des organischen Moleküls in einem organischen Lösungsmittel auf, wobei der Substituenten zur Erhöhung der Löslichkeit insbesondere ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
- verzweigten oder unverzweigten oder zyklischen langkettigen Perfluoralkylketten einer Länge von C1 bis C30, und
- kurzkettigen Polyethern mit einer Kettenlänge von 3 bis 50 Wiederholungseinheiten.

In einer weiteren Ausführungsform sind die beiden Phenylringe in Formel 1*, 1', A* und A' unabhängig voneinander ein substituierter oder unsubstituierter Phenylring.

In einer weiteren Ausführungsform sind die drei Phenylringe des trimeren Systems unabhängig voneinander ein substituierter oder unsubstituierter Phenylring.

Eine Ausführungsform der erfindungsgemäßen organischen Moleküle betrifft solche, bei denen mindestens einer der Substituenten F oder F' oder F" ein Heteroatom X aufweist, über das der Substituent kovalent an den Phenylring gebunden ist, wobei das Heteroatom insbesondere N ist.

Mit einer von Carbazol abgeleiteten Gruppe NArAr¹ ergeben sich folgende Strukturen der Formeln 2 und 3

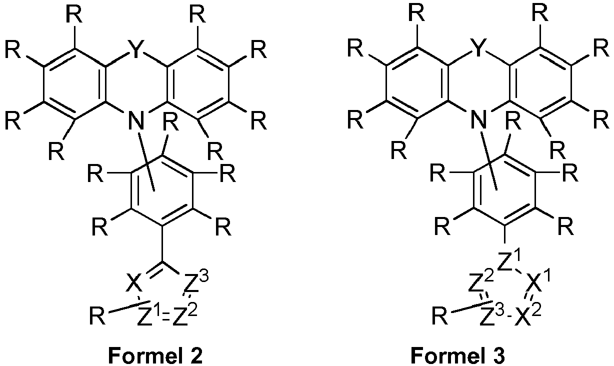

In Formel 2 und 3 sind X, X¹, X² jeweils unabhängig von einander ausgewählt aus der Gruppe bestehend aus dem Fragment CR und N. Y ist eine kovalente Einfachbindung oder ausgewählt aus der Gruppe bestehend aus, O, S, NR, CRR', C=CRR', C=NR und SiRR'. Z¹-Z³ sind jeweils unabhängig voneinander ausgewählt aus der Gruppe bestehend aus dem Fragment CRR', CR, NR, N und O, wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen X und Z¹ immer eine Einfachbindung vorhanden ist.

Jedes R und R' ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R' auch miteinander ein mono- oder polycyclisches, aliphatisches, aromatisches und/oder benzoannelliertes Ringsystem bilden. Ein Rest R des Phenylrings ist jeweils ersetzt (symbolisiert durch den in den Benzolring hineinreichenden Strich). R² ist bei jedem Auftreten gleich oder verschieden H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme. Zwei oder mehrere dieser Substituenten R² können dabei auch miteinander ein mono- oder polycyclisches, aliphatisches, aromatisches und/oder benzoannelliertes Ringsystem bilden.

R³ ist bei jedem Auftreten gleich oder verschieden H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können. Dabei können zwei oder mehrere Substituenten R³ auch miteinander ein mono- oder polycyclisches, aliphatisches Ringsystem bilden.

In einer Ausführungsform weist das organische Molekül gemäß Formel 2 eine Struktur der Formel B und das organische Molekül gemäß Formel 3 eine Struktur der Formel C auf: 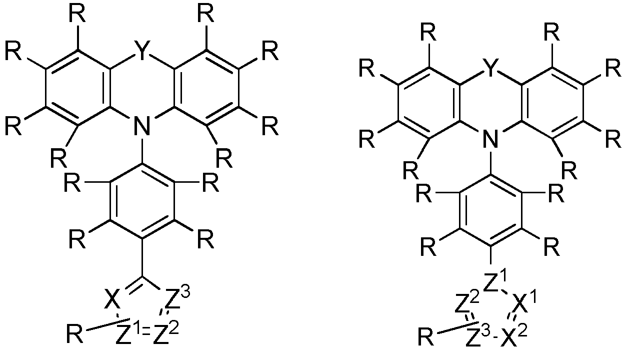 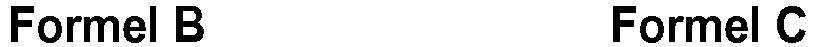 wobei sich die NArAr¹-Einheit und der 5-Ring-Heterozyklus in para-Position zueinander befinden und im Übrigen die bei Formel 2 und 3 angegebenen Definitionen gelten.

In einer Ausführungsform weist das organische Molekül eine Struktur der Formel 2' oder 3' auf, 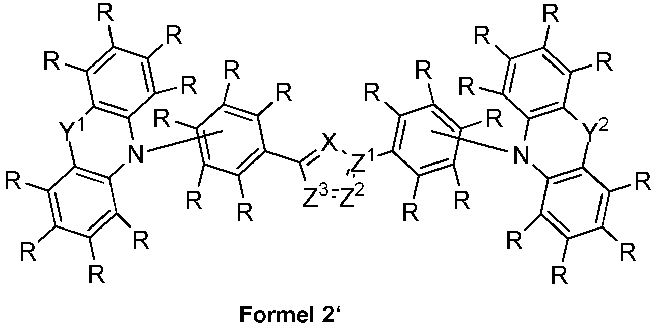 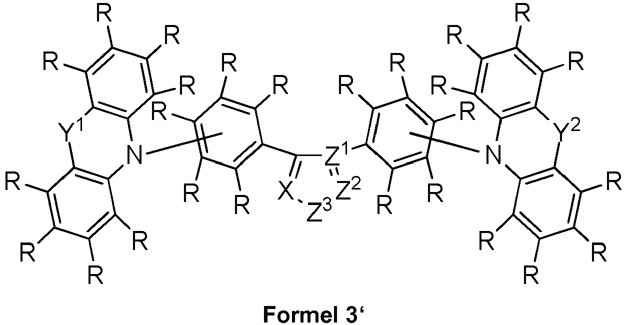 mit
X = ausgewählt aus der Gruppe bestehend aus N und dem Fragment CR;
Y¹, Y² = unabhängig voneinander ausgewählt aus der Gruppe bestehend aus einer direkten Bindung, O, S, NR, CRR', C=CRR', C=NR und SiRR';
Z¹ = ausgewählt aus der Gruppe bestehend aus C, N und dem Fragment CR;
Z² = ausgewählt aus der Gruppe bestehend aus N und dem Fragment NR;
Z³ = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X bzw. Z³ und X immer eine Einfachbindung vorhanden ist;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

In einer Ausführungsform weist das organische Molekül gemäß Formel 2'eine Struktur der Formel B'und das organische Molekül gemäß Formel 3' eine Struktur der Formel C' auf: 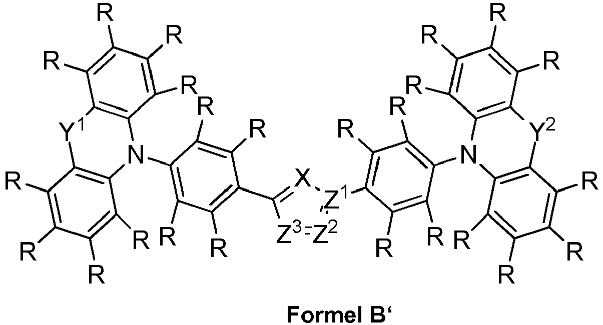 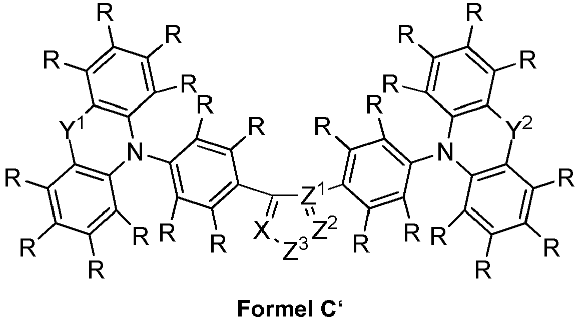 wobei sich die NArAr¹-Einheit und der 5-Ring-Heterozyklus jeweils in para-Position zueinander befinden und im Übrigen die bei Formel 2' und 3' angegebenen Definitionen gelten.

Erfindungsgemäß sind auch die über einen unsubstituierten oder substituierten Phenylring als Spacer verbundenen Dimere, die eine Struktur der Formel 2* oder 3* aufweisen.

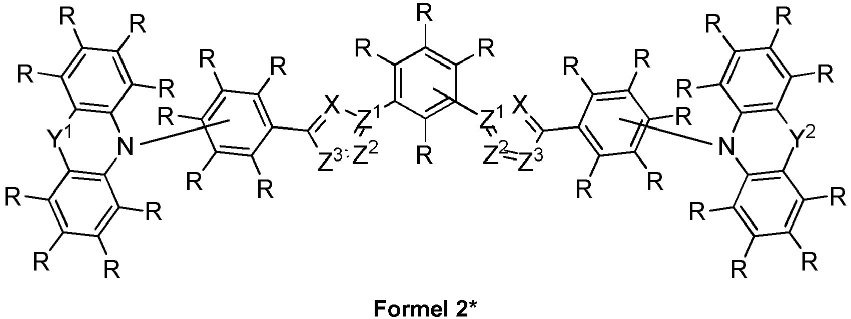

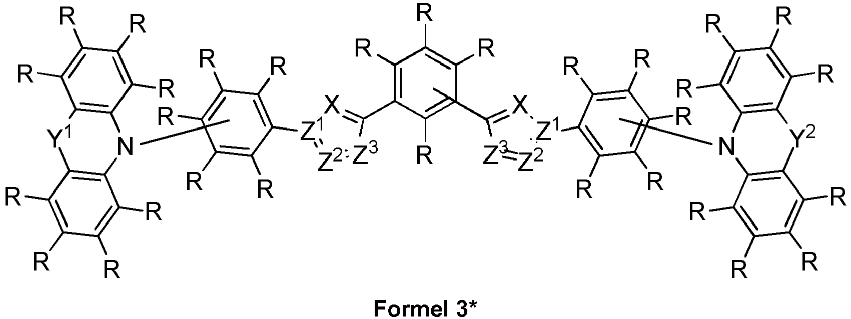

Dabei gilt:
X = ausgewählt aus der Gruppe bestehend aus N und dem Fragment CR;
Y¹, Y² = unabhängig voneinander eine kovalente Einfachbindung oder ausgewählt aus der Gruppe bestehend aus O, S, NR, CRR', C=CRR', C=NR und SiRR';
Z¹ = ausgewählt aus der Gruppe bestehend aus C, N und dem Fragment CR;
Z² = ausgewählt aus der Gruppe bestehend aus N und dem Fragment NR;
Z3 = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X bzw. Z³ und X immer eine Einfachbindung vorhanden ist;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

In einer Ausführungsform weist das organische Molekül gemäß Formel 2* eine Struktur der Formel B* und das organische Molekül gemäß Formel 3* eine Struktur der Formel C* auf: 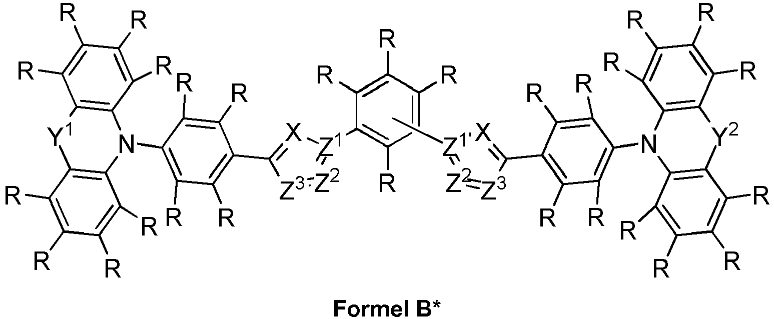 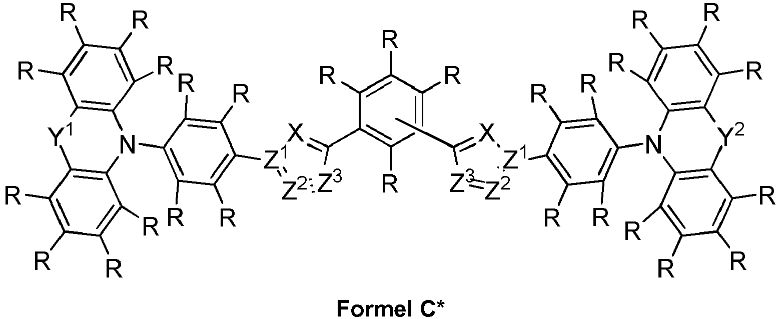 wobei sich die NArAr¹-Einheit und der 5-Ring-Heterozyklus jeweils in para-Position zueinander befinden und im Übrigen die bei Formel 2* und 3* angegebenen Definitionen gelten.

Erfindungsgemäß sind auch die in Analogie zu den Formeln 2* und 2* gebildeten Trimere der Formel 2** und 3**, in denen drei Einheiten über einen unsubstituierten oder substituierten Phenylring als Spacer miteinander verbunden sind. 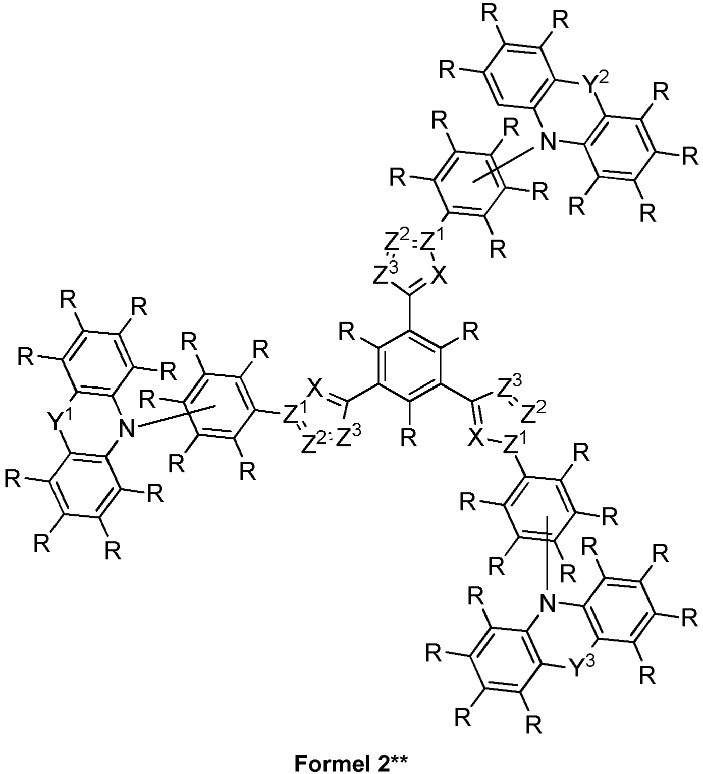 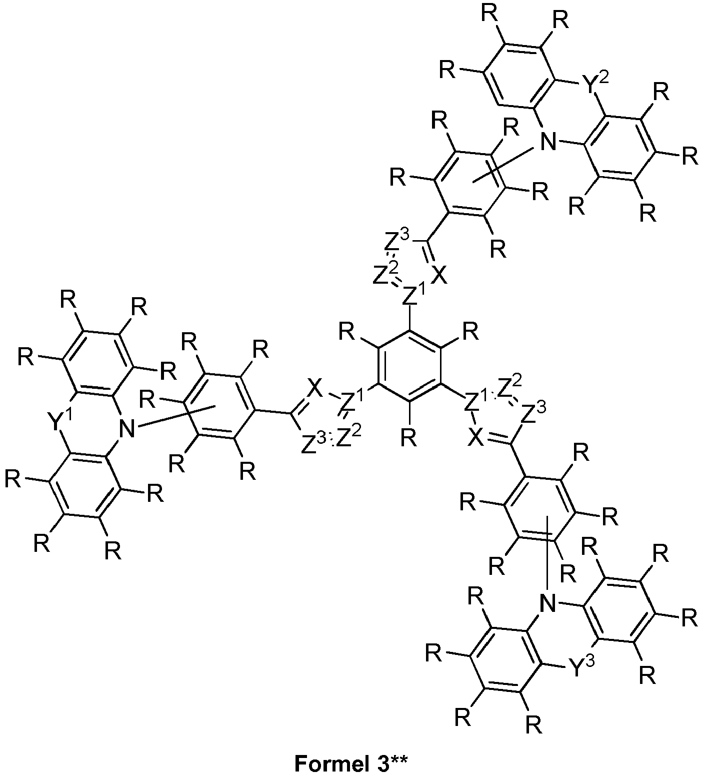 Dabei gilt:
Y¹, Y², Y³ = unabhängig voneinander eine kovalente Einfachbindung oder ausgewählt aus der Gruppe bestehend aus O, S, NR, CRR', C=CRR', C=NR und SiRR'; im Übrigen gelten die bei Formel 2* und 3* angegebenen Definitionen.

In einer Ausführungsform weist das organische Molekül gemäß Formel 2** eine Struktur der Formel B** und das organische Molekül gemäß Formel 3** eine Struktur der Formel C** auf: 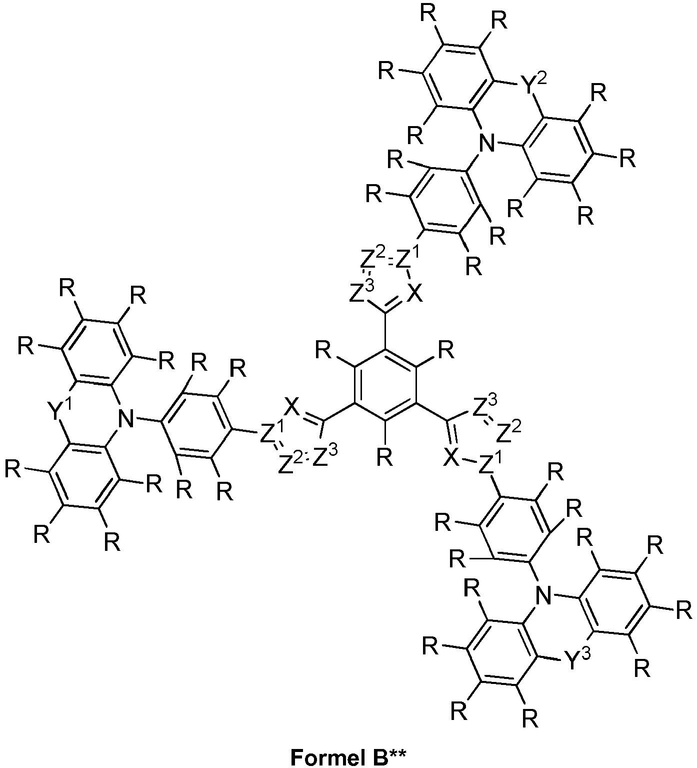 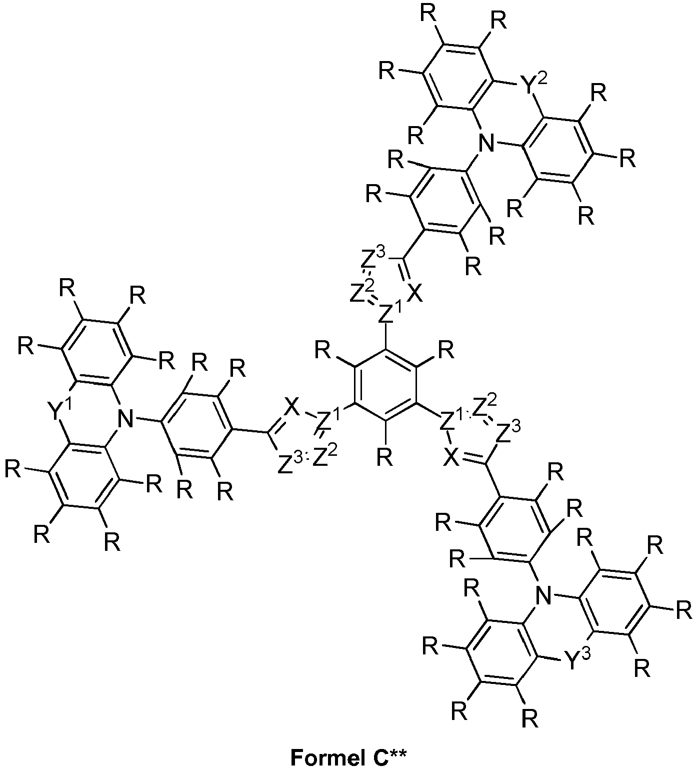 wobei sich die NArAr¹-Einheit und der 5-Ring-Heterozyklus jeweils in para-Position zueinander befinden und im Übrigen die bei Formel 2* und 3* angegebenen Definitionen gelten.

Die Erfindung betrifft in einem Aspekt ein Verfahren zur Herstellung der erfindungsgemäßen organischen Moleküle aufweisend eine [i+j]-Cycloaddition (hier als Clickreaktion bezeichnet) des mit NArAr¹ versehenen Phenylrings, der eine zur Clickreaktion befähigte Gruppe ausgewählt aus einem Dipolarophil und 1,3-Dipol trägt, mit einer entsprechenden komplementären Gruppe, die ausgewählt ist aus einem 1,3-Dipol und einem Dipolarophil, wobei ein unsubstituierter oder substituierter 5-gliedriger Ring F bzw. F' ausgebildet wird. Komplementär zueinander ist jeweils ein Dipolarophil und ein 1,3-Dipol.

### Allgemeine Reaktionsschemata zur Cycloaddition:

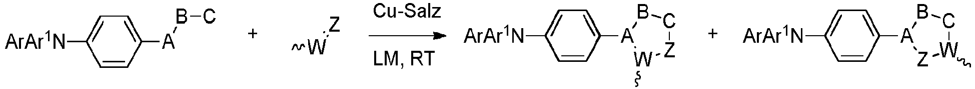

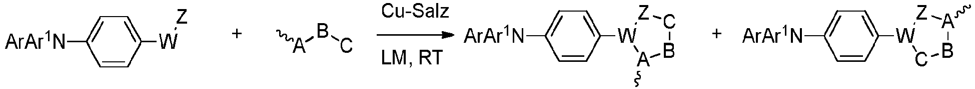

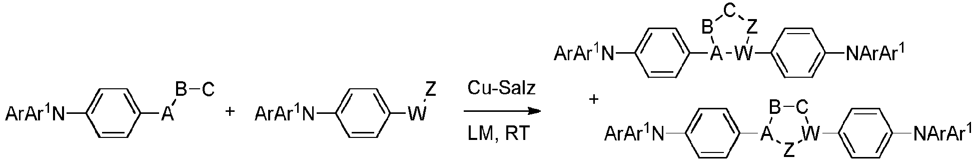

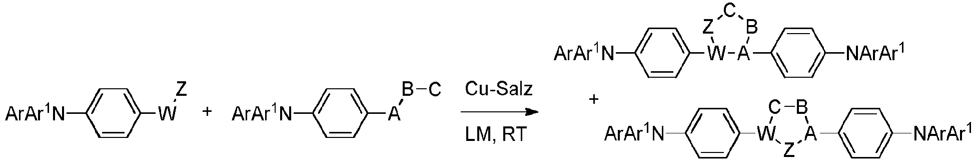

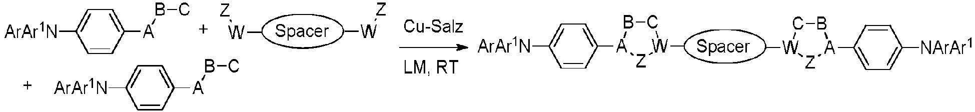

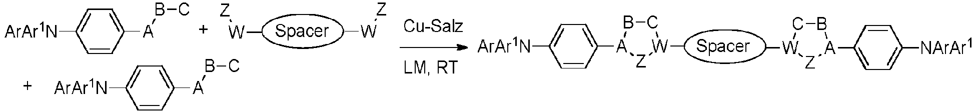

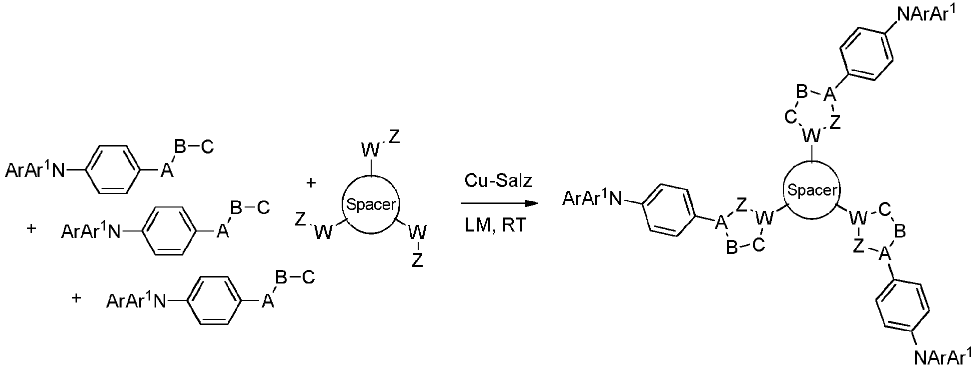

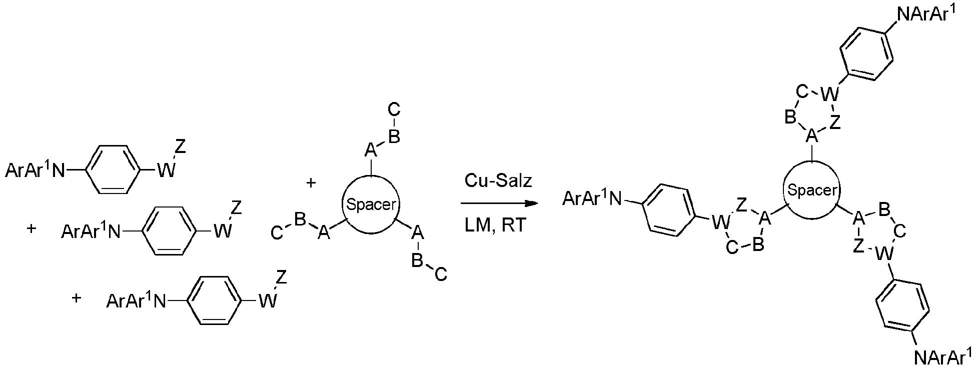

A-B-C ist dabei ein 1,3-Dipol, W-Z ein Dipolarophil, die miteinander eine dipolare Cycloaddition (Clickreaktion) eingehen, wobei ein unsubstituierter oder substituierter 5-gliedriger Ring ausgebildet wird.

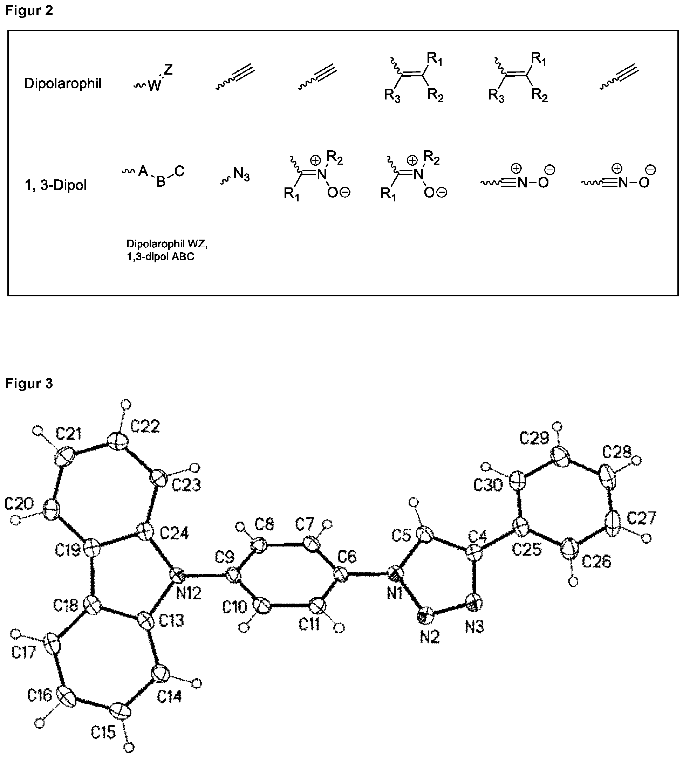

Beispiele für Dipolarophile und entsprechende 1,3-Dipole sind in Figur 2 angegeben.

Vorteilhaft ist die Synthese über eine Cycloaddition, da die entsprechenden Startmaterialien in der Regel gut verfügbar sind und die Cycloaddition ebenso in der Regel in guten Ausbeuten mit einem geringem Aufreinigungsaufwand durchführen lassen. Hierzu wird beispielsweise das nicht-fluoreszierende *N*-(4-azidophenyl)-carbazol verwendet.

Für die Cycloaddition eignet sich beispielsweise eine Kupfer-katalysierte Alkin-Azid-Click-Reaktion mit dem Katalysatorsystem Kupfer(I)-iodid in Lösungsmitteln wie Diisopropylamin. Ferner lassen sich 1,3-Dipolare Cycloadditionen unter Verwendung von cyclischen Octinen wie Cyclooctin durchführen. Triebkraft dieser Reaktion ist Reduzierung der Ringspannung, weswegen der Fachmann in diesem Zusammenhang auch von engl. *strain promoted azide alkyne cycloaddition* spricht. (N. J. Agard, J. A. Prescher and C. R. Bertozzi, J. Am. Chem. Soc., 2004, 126, 15046-15047). Typische Ausbeuten für derartige Umsetzungen liegen bei 74 % bis 98 %.

In einer Ausführungsform weist das Verfahren zur Herstellung der erfindungsgemäßen organischen Moleküle den Schritt der Substitution mindestens einer der Gruppen Phenylring, F, F', F" und/oder NArAr¹ mit mindestens einem Substituenten zur Erhöhung der Löslichkeit auf, der ausgewählt ist aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30 und
- kurzkettigen Polyethern mit einer Kettenlänge von 3 bis 50 Wiederholungseinheiten.

Die Erfindung betrifft auch die Verwendung eines erfindungsgemäßen organischen Moleküls als Emitter oder Absorber in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

Der Anteil des erfindungsgemäßen organischen Moleküls am Emitter oder Absorber beträgt in einer Ausführungsform 1 % bis 99 %, insbesondere beträgt der Anteil am Emitter in optischen Licht emittierenden Bauelementen, insbesondere in OLEDs, zwischen 5 und 80 %. In einer alternativen Ausführungsform beträgt der Anteil des organischen Moleküls am Emitter oder Absorber 100 %.

Erfindungsgemäß sind auch entsprechende optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

In einer Ausführungsform des erfindungsgemäßen Bauelements wird das organische Molekül als Emissionsmaterial in einer Emissionsschicht eingesetzt wird, wobei sie in Kombination mit einem Matrixmaterial oder insbesondere als Reinschicht oder eingesetzt werden kann.

In einer weiteren Ausführungsform beträgt der Anteil des organischen Moleküls als Emissionsmaterial in einer Emissionsschicht in optischen Licht emittierenden Bauelementen, insbesondere in OLEDs, zwischen 5 % und 80 %.

In einer weiteren Ausführungsform des erfindungsgemäßen Bauelements ist die ein erfindungsgemäßes organisches Molekül aufweisende lichtemittierende Schicht auf ein Substrat aufgebracht.

Erfindungsgemäß ist auch ein optoelektronisches Bauelement, aufweisend ein erfindungsgemäßes organisches Molekül, welches ein Substrat, eine Anode und eine Kathode aufweist, wobei die Anode und die Kathode auf das Substrat aufgebracht ist, und die lichtemittierende Schicht zwischen Anode und Kathode aufgebracht ist.

In einer Ausführungsform betrifft die Erfindung ein optoelektronisches Bauelement, wobei die lichtemittierende Schicht ausschließlich ein erfindungsgemäßes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das erfindungsgemäße optoelektronische Bauelement neben dem erfindungsgemäßen organischen Molekül auch ein Hostmaterial auf, dessen Triplett (T1)- und Singulett (S1)-Energieniveaus energetisch höher liegen als die Triplett (T1)- und Singulett (S1)-Energieniveaus des organischen Moleküls, wobei die Anode und die Kathode auf das Substrat aufgebracht ist, und die lichtemittierende Schicht zwischen Anode und Kathode aufgebracht ist.

In einer weiteren Ausführungsform weist das erfindungsgemäße optoelektronische Bauelement ein Substrat, eine Anode, eine Kathode und mindestens je eine löcher- und elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett (T1)- und Singulett (S1)-Energieniveaus energetisch höher liegen als die Triplett (T1)- und Singulett (S1)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer Ausführungsform weist das erfindungsgemäße optoelektronische Bauelement ein Substrat, eine Anode, eine Kathode und mindestens je eine löcher- und eine elektroneninjizierende Schicht, und mindestens je eine löcher- und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett (T1)- und Singulett (S1)-Energieniveaus energetisch höher liegen als die Triplett (T1)- und Singulett (S1)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

Die Beschreibung betrifft in einem Aspekt auch ein lichtemittierendes Material, aufweisend ein erfindungsgemäßes organisches Molekül und ein Hostmaterial, wobei die Triplett (T1)- und Singulett (S1)-Energieniveaus des Hostmaterials energetisch höher liegen als die Triplett (T1)- und Singulett (S1)-Energieniveaus des organischen Moleküls, und wobei das organische Molekül Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 3000 cm⁻¹ aufweist.

Ein anderer Aspekt der Erfindung betrifft ein Verfahren zur Herstellung eines optoelektronischen Bauelements aufweisend ein erfindungsgemäßes organisches Molekül.

In einer Ausführungsform ist das Verfahren gekennzeichnet durch das Aufbringen des organischen Moleküls auf einen Träger, wobei das Aufbringen bevorzugt nass-chemisch, mittels kolloidaler Suspension oder mittels Sublimation erfolgt.

In einer weiteren Ausführungsform des Verfahrens wird mindestens eine Schicht
- mit einem Sublimationsverfahren beschichtet
- mit einem OVPD (Organic Vapour Phase Deposition) Verfahren beschichtet
- mit Hilfe einer Trägergassublimation beschichtet oder
- aus Lösung oder mit einem beliebigen Druckverfahren hergestellt.

Beschrieben ist darüber hinaus auch ein Verfahren zur Veränderung der Emissions- und/oder Absorptionseigenschaften eines elektronischen Bauelements eine erfindungsgemäßes organisches Molekül in ein Matrixmaterial zur Leitung von Elektronen oder Löchern in einem optoelektronischen Bauelement eingebracht wird.

Die Erfindung betrifft zudem in einem weiteren Aspekt die Verwendung eines erfindungsgemäßen Moleküls zur Umwandlung von UV-Strahlung oder von blauem Licht in sichtbares Licht, insbesondere in grünes, gelbes oder rotes Licht (down-Konversion), insbesondere in einem optoelektronischen Bauelement.

Die Anknüpfung von NArAr¹ und F bzw. F' bzw. F" an die Phenylringe führt dazu, dass sich diese Gruppen zueinander verdrehen müssen und somit nicht parallel und damit in Konjugation zueinander stehen, wodurch diese elektronisch entkoppelt werden. In einer Ausführungsform führt die Anknüpfung von NArAr¹ und F bzw. F' bzw. F" an die Phenylringe dazu, dass sich diese Gruppen zueinander verdrehen müssen und somit orthogonal zueinander stehen. Diese Entkopplung kann beispielsweise durch quantenmechanische Berechnungen des HOMO und LUMO nachvollzogen werden. Diese beiden Grenzorbitale sollten demnach keine bzw. eine möglichst geringe Überlappung zeigen. Das pi-System des zentralen Phenylrings bzw. der zentralen Phenylringe kann dabei hauptsächlich entweder Teil des HOMO oder des LUMO sein.

Zur räumlichen Trennung der Orbitale HOMO und LUMO sind die aromatischen und heteroaromatischen Ringsysteme der erfindungsgemäßen Moleküle gegeneinander verdrillt. Durch diese Verdrillung ist die Konjugation der pi-Systeme gebrochen, wodurch HOMO und LUMO auf unterschiedlichen Molekülteilen lokalisiert und nicht über das gesamte Molekül delokalisiert vorliegen. Diese Verdrillung kann beispielsweise durch Röntgenkristallografie nachgewiesen werden (siehe auch Figur 2).

Die Ergebnisse von UVVIS-Messungen in Lösung (siehe auch Tabelle 1) legen nahe, dass die gewünschte Verdrillung der pi-Systeme nicht nur in Kristallen, sondern auch in Lösung und im amorphen Festkörper auftritt. Die Absorptionsspektren stellen somit die Superposition der Absorptionsspektren der isolierten pi-Systeme dar. Weitere breite, unstruktierte Banden zwischen 300 nm und 350 nm mit geringen Absorptionskoeffizienten treten aufgrund von Charge-Transfer-Übergängen auf, die zur Emission von sichtbarem Licht führen. Außerdem finden sich in der Tabelle Daten zur Emissionsfarbe der Verbindungen, die bei den gezeigten Beispielen im blauen Spektralbereich liegt.

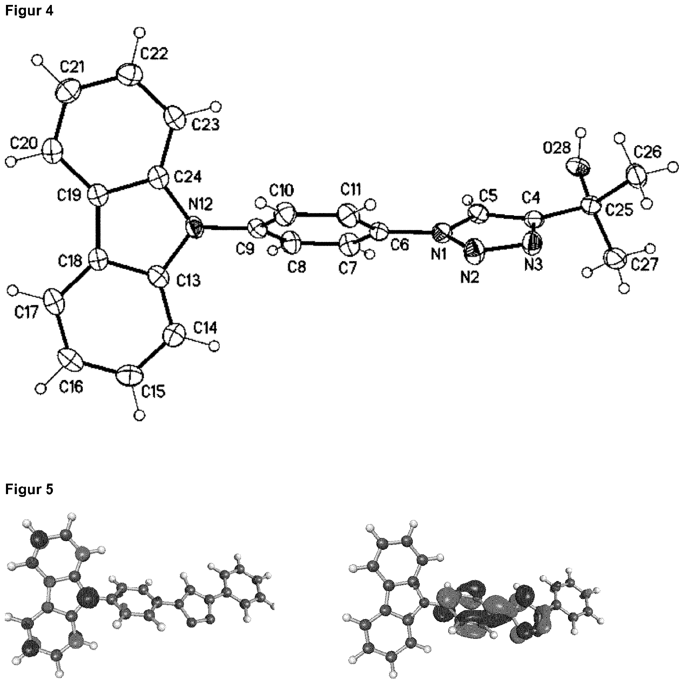

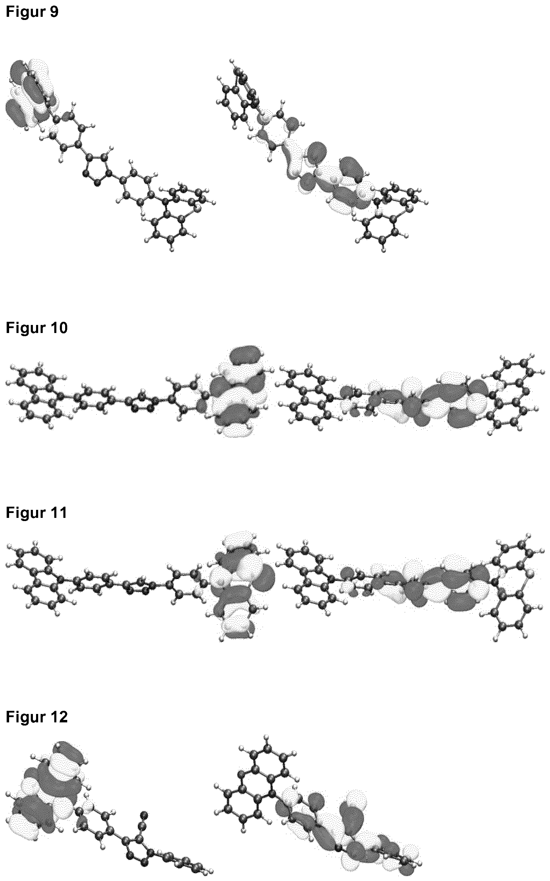

Durch quantenchemische Rechnungen (DFT, B3-LYP/def2-TZVP Level) (S. Fery-Forgues and D. Lavabre, J. Chem. Educ., 1999, 76, 1260-1264) konnten die Grenzorbitale visualisiert werden, wie in Figur 5 bis 13 dargestellt ist. Wie gewünscht liegt das HOMO auf der elektronenspendenen Donorgruppe, während das LUMO auf der elektronenziehenden Akzeptorgruppe liegt. Die Emission der erfindungsgemäßen Verbindungen beruht demnach auf der Verdrillung zwischen Donor und Akzeptor, wodurch ein geringer ΔE_{ST}-Wert hervorgerufen wird.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind insbesondere ausgewählt aus der Gruppe bestehend aus N, O und S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind insbesondere ausgewählt aus der Gruppe bestehend aus N, O und S. Unter einem aromatischen oder heteroaromatischen Ringsystem im Sinne dieser Erfindung soll ein System verstanden werden, das nicht notwendigerweise nur Aryl- oder Heteroaryl-gruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluor-methyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-0ctyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁ bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spiro-bifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroiso-truxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazin-imidazol, Chinoxalinimidazol, Oxazol, Benzoxazol, Naphthoxazol, Anthroxazol, Phenanthroxazol, Isoxazol, 1,2-Thiazol, 1,3-Thiazol, Benzo-thiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Aza-carbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thia-diazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

### Beispiele

### Synthese von N-(4-Azidophenyl)carbazol 1

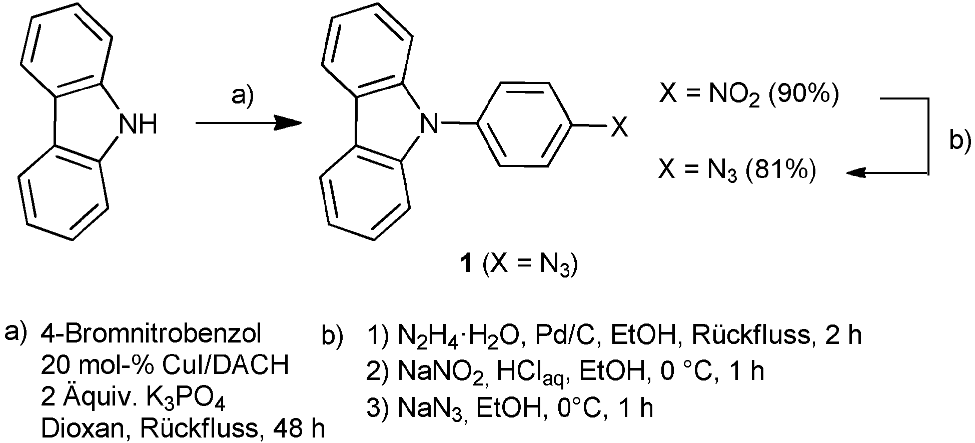

*9-(4-Nitrophenyl)-9H-carbazol:* Die Synthese erfolgte nach einer modifizierten Literaturvorschrift 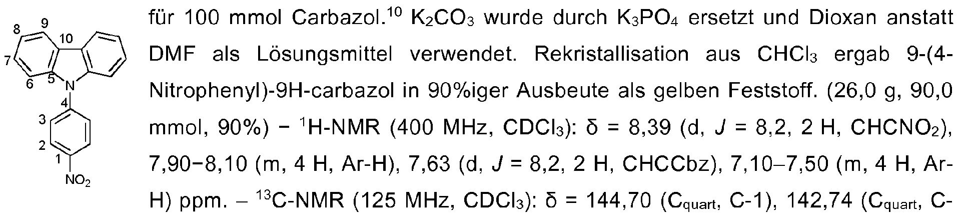 für 100 mmol Carbazol.¹⁰ K₂CO₃ wurde durch K₃PO₄ ersetzt und Dioxan anstatt DMF als Lösungsmittel verwendet. Rekristallisation aus CHCl₃ ergab 9-(4-Nitrophenyl)-9H-carbazol in 90%iger Ausbeute als gelben Feststoff. (26,0 g, 90,0 mmol, 90%) - ¹H-NMR (400 MHz, CDCl₃): δ = 8,39 (d, *J* = 8,2, 2 H, CHCNO₂), 7,90-8,10 (m, 4 H, Ar-H), 7,63 (d, *J* = 8,2, 2 H, CHCCbz), 7,10-7,50 (m, 4 H, Ar-H) ppm. - ¹³C-NMR (125 MHz, CDCl₃): δ = 144,70 (C_{quart}, C-1), 142,74 (C_{quart}, C-4), 138,41 (C_{quart}, 2 C, C-5), 125,61 (+, 2 C, C-3), 125,12 (+, 2 C, C-3), 124,45 (+, 2 C, C-2), 123,73 (C_{quart}, 2 C, C-10), 120,24 (+, 2 C, C-9), 119,58 (+, 2 C, C-8), 109,52 (+, 2 C, C-6) ppm. - IR (ATR): v = 3416 (vw), 3049 (vw), 2923 (vw), 1892 (vw), 1702 (vw), 1594 (s), 1502 (vs), 1480 (s), 1450 (s), 1365 (w), 1342 (vs), 1316 (vs), 1227 (vs), 1177 (m), 1121 (w), 1101 (s), 1003 (w), 915 (m), 840 (vs), 741 (vs), 718 (vs), 689 (vs), 637 (m), 617 (m), 410 (s) cm⁻¹. - MS (70 eV, EI), *m*/*z* (%): 292 (2) [M]⁺, 248 (1) [M-NO₂]⁺, 219 (1), 167 (100) [M-NO₂-Ph]⁺, 139 (10), 77 (73), 50 (48). - HR-EIMS (C₁₈H₁₂N₂O₂): ber. 288,0898; gef. 288,0896. *9-(4-Aminophenyl)-9H-carbazol:* Verfahren nach einer modifizierten Literaturvorschrift.¹¹ Zu einer 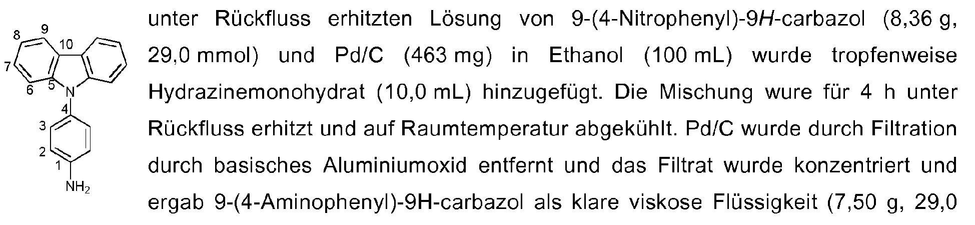 unter Rückfluss erhitzten Lösung von 9-(4-Nitrophenyl)-9*H*-carbazol (8,36 g, 29,0 mmol) und Pd/C (463 mg) in Ethanol (100 mL) wurde tropfenweise Hydrazinemonohydrat (10,0 mL) hinzugefügt. Die Mischung wure für 4 h unter Rückfluss erhitzt und auf Raumtemperatur abgekühlt. Pd/C wurde durch Filtration durch basisches Aluminiumoxid entfernt und das Filtrat wurde konzentriert und ergab 9-(4-Aminophenyl)-9H-carbazol als klare viskose Flüssigkeit (7,50 g, 29,0 mmol) in 99%iger Ausbeute. Das Produkt wurde ohne weitere Aufreinigung direkt in den nächsten Schritt eingesetzt. - ¹H-NMR (300 MHz, DMSO-d6): δ = 8,19 (d, *J* = 8,1 Hz, Ar-H, 2H); 7,40 (t, ³*J_{H-H}* = 7,5 Hz, Ar-H, 2 H), 7,27-7,21 (m, Ar-H, 4 H), 7,18 (d, ³*J*_{H-H}= 9,0 Hz, Ar-H, 2 H), 6,81 (d, , ³*J_{H-H}*= 8,4 Hz, Ar-H, 2 H), 5,35 (s, NH₂, 2 H) ppm.

*9-(4-Azidophenyl)-9H-carbazol* **1:** Eine gerührte Suspension von 9-(4-Aminophenyl)-9*H*-carbazol 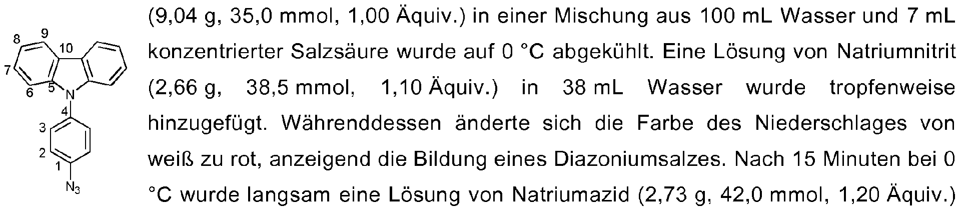 (9,04 g, 35,0 mmol, 1,00 Äquiv.) in einer Mischung aus 100 mL Wasser und 7 mL konzentrierter Salzsäure wurde auf 0 °C abgekühlt. Eine Lösung von Natriumnitrit (2,66 g, 38,5 mmol, 1,10 Äquiv.) in 38 mL Wasser wurde tropfenweise hinzugefügt. Währenddessen änderte sich die Farbe des Niederschlages von weiß zu rot, anzeigend die Bildung eines Diazoniumsalzes. Nach 15 Minuten bei 0 °C wurde langsam eine Lösung von Natriumazid (2,73 g, 42,0 mmol, 1,20 Äquiv.) in 38 mL Wasser hinzugefügt. Der Beginn des zweiten Reaktionsschrittes wird angezeigt durch eine starke Stickstoffbildung, was zum Schäumen führte. Daher ist ein Reaktionskolben einer angemessenen Größe (500 mL oder größer) aus Sicherheitsgründen empfohlen. Nach der kompletten Zugabe wurde das Eisbad entfernt und die Reaktionsmischung für 30 Minuten gerührt. Das Rohprodukt wurde durch Filtration der Reaktionsmischung, gefolgt von Waschen mit Wasser (500 mL) und Methanol (30 mL) erhalten und weiter aufgereinigt durch Flash-Chromatographie an Kieselgel und Cyclohexan/Ethylacetat /10:1) als Eluent. Die Verbindung **1** wurde nach Trocknung in 81 %iger Aubeute als gelblicher Feststoff isoliert und bei 4 °C in einem dunklen Kolben gelagert um die Zersetzung des Azids zu vermeiden. (8,10 g, 28,5 mmol) - R_{f} = 0,24 - ¹H-NMR (400 MHz, CDCl₃): δ = 8,06 (dt, , ³*J_{H-H}* = 7,8, 1,0 Hz, 2H, Ar-H), 7,53-7,40 (m, 2H, Ar-H), 7,40-7,10 (m, 8H, Ar-H) ppm. - ¹³C-NMR (125 MHz, CDCl₃): δ = 140,90 (+, 2 C, C-2), 139,20 (C_{quart}, C-4), 134,44 (C_{quart}, 2 C, C-5), 128,63 (+, 2 C, C-3), 126,96 (C_{quart}, C-1), 125,84 (+, 2 C, C-2), 123,59 (C_{quart}, 2 C, C-10), 120,35 (+, 2 C, C-9), 120,09 (+, 2 C, C-8), 109,68 (+, 2 C, C-6) ppm. - IR (DRIFT): v = 3416 (vw), 3052 (vw), 2412 (vw), 2254 (vw), 2115 (vs), 2115 (vs), 1596 (m), 1507 (w), 1478 (vs), 1450 (s), 1364 (vs), 1336 (w), 1319 (w), 1289 (w), 1275 (s), 1230 (s), 1182 (s), 1148 (s), 1128 (m), 1110 (m), 1014 (m), 998 (w), 932 (w), 912 (w), 855 (w), 832 (w), 812 (w), 777 (w), 752 (vs), 725 (vs), 665 (m), 641 (m), 621 (m), 570 (m), 531 (m), 510 (m), 448 (m), 425 (m) cm⁻¹. - MS (70 eV, EI), *m*/*z* (%): 284 (70) [M]⁺, 256 (100) [M-N₂]⁺, 229 (13), 167 (50) [Cbz]⁺, 153 (29), 136 (18), 105 (50) 77 (56), 55 (39). - HR-EIMS (C₁₈H₁₂N₄): ber. 284,1062; gef. 284,1063. - Elementaranalyse für C₁₈H₁₂N₄: ber. C 76,04, H 4,25, N 19,71; gef. C 76,33, H 4,37, N 19,33.

### Reaktion von N-4-Azidophenyl)carbazol 1 mit terminalen Alkinen

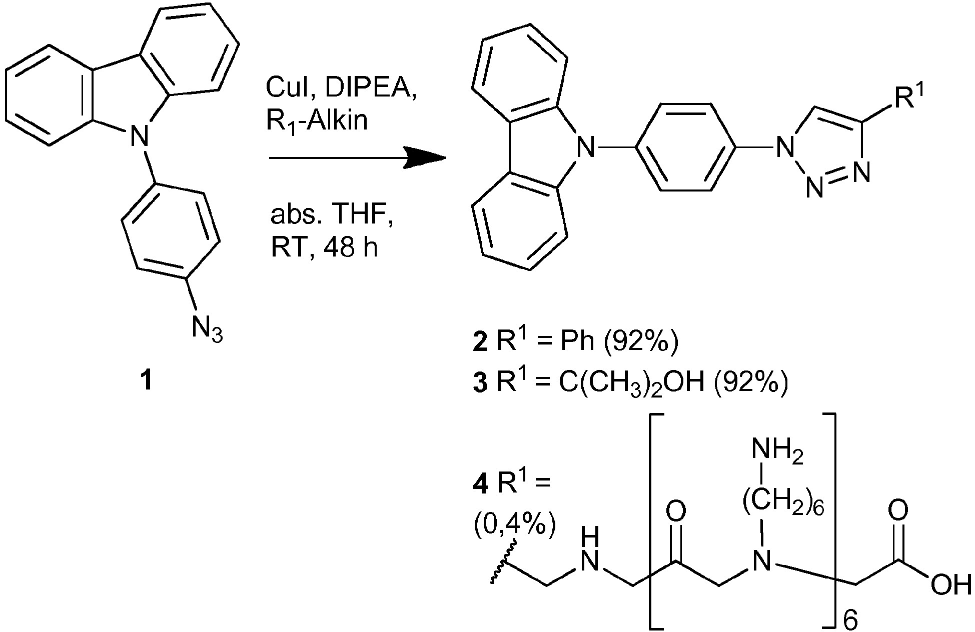

*9-(4-(4-Phenyl-1H-1,2,3-triazol-1-yl)phenyl)-9H-carbazol* **2:** In einem geschlossenen Reaktionsgefäß 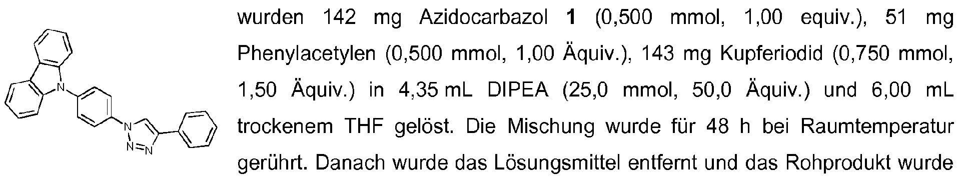 wurden 142 mg Azidocarbazol **1** (0,500 mmol, 1,00 equiv.), 51 mg Phenylacetylen (0,500 mmol, 1,00 Äquiv.), 143 mg Kupferiodid (0,750 mmol, 1,50 Äquiv.) in 4,35 mL DIPEA (25,0 mmol, 50,0 Äquiv.) und 6,00 mL trockenem THF gelöst. Die Mischung wurde für 48 h bei Raumtemperatur gerührt. Danach wurde das Lösungsmittel entfernt und das Rohprodukt wurde durch Flash-Chromatographie an Kieselgel mit Cyclohexan/Ehtylacetat (8:1) als Eluent aufgereinigt. Erneute Aufreinigung mittels einer HPLC ergab die Verbindung **2** als farblose Kristalle in 92 %iger Ausbeute. (28 mg, 0,073 mmol) - mp: 205,5 °C - ¹H-NMR (400 MHz, CDCl₃): δ = 8,30 (s, 1 H, CHN), 8,20-8,15 (m, 2 H, Ar-H), 8,08-8,03 (m, 2 H, Ar-H), 8,00-7,94 (m, 2 H, Ar-H), 7,81-7,76 (m, 2 H, Ar-H), 7,53-7,44 (m, 6 H, Ar-H), 7,44-7,38 (m, 1 H, Ar-H), 7,38-7,31 (m, 2 H, Ar-H) ppm. - ¹³C-NMR (100 MHz, CDCl₃): δ = 148,7 (C_{quart}, C_{quart}CHN), 140,5 (C_{quart}, 2 C, C_{quart}C_{quart}N), 138,2 (C_{quart}, C_{quart}N), 135,7 (C_{quart}, C_{quart}N), 130,0 (C_{quart}, C_{quart}C_{quart}CH), 129,0 (+, 2 C, C_{Ar}), 128,6 (+, C_{Ar}), 128,3 (+, 2 C, C_{Ar}), 126,2 (+, 2 C, C_{Ar}), 125,9 (+, 2 C, C_{Ar}), 123,6 (C_{quart}, 2 C, C_{quart}C_{quart}N), 122,0 (+, 2 C, C_{Ar}), 120,5 (+, 2 C, C_{Ar}), 120,4 (+, 2 C, C_{Ar}), 117,5 (+, C_{Ar}), 109,5 (+, 2 C, C_{Ar}) ppm. - IR (ATR): v = 2921 (vw), 1677 (w), 1606 (w), 1523 (m), 1478 (w), 1450 (m), 1415 (w), 1366 (w), 1332 (w), 1318 (w), 1224 (m), 1181 (w), 1148 (w), 1113 (w), 1071 (w), 1035 (w), 1025 (w), 991 (w), 908 (w), 844 (w), 828 (w), 792 (w), 776 (vw), 747 (m), 722 (m), 687 (m), 638 (w), 619 (w), 567 (w), 542 (w), 502 (w), 465 (w), 424 (w) cm⁻¹. - MS (70 eV, EI), *m*/*z* (%): 386,2 (16) [M]⁺, 358,2 (100) [M-N₂]⁺, 241,1 (23). - HR-EIMS (C₂₆H₁₈N₄): ber. 386,1531; gef. 386,1530.
Die Röntgenstruktur von 2 ist in Figur 3 angegeben.

*2-(1-(4-(9H-Carbazol-9-yl)phenyl)-1-1,2,3-triazol-4-yl)propan-2-ol* **3:** In einem geschlossenen 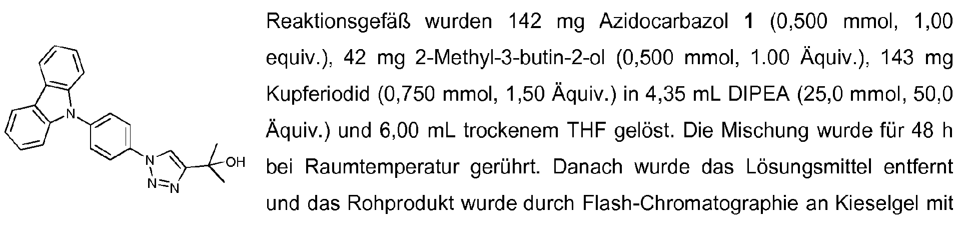 Reaktionsgefäß wurden 142 mg Azidocarbazol **1** (0,500 mmol, 1,00 equiv.), 42 mg 2-Methyl-3-butin-2-ol (0,500 mmol, 1.00 Äquiv.), 143 mg Kupferiodid (0,750 mmol, 1,50 Äquiv.) in 4,35 mL DIPEA (25,0 mmol, 50,0 Äquiv.) und 6,00 mL trockenem THF gelöst. Die Mischung wurde für 48 h bei Raumtemperatur gerührt. Danach wurde das Lösungsmittel entfernt und das Rohprodukt wurde durch Flash-Chromatographie an Kieselgel mit Cyclohexan/Ehtylacetat (2:1) als Eluent aufgereinigt. Erneute Aufreinigung mittels einer HPLC ergab die Verbindung **3** als ockerfarbene Kristalle in 92 %iger Ausbeute. (169 mg, 0,459 mmol). - mp: 155,1 °C - ¹H-NMR (400 MHz, CDCl₃): δ = 8,18 - 8,14 (m, 2 H, Ar-H), 8,02 - 7,96 (m, 3 H, Ar-H), 7,78 - 7,74 (m, 2 H, Ar-H), 7,46 - 7,42 (m, 4 H, Ar-H), 7,36 - 7,30 (m, 2 H, Ar-H), 1,76 (s, 6 H, CH₃) ppm. - ¹³C-NMR (100 MHz, CDCl₃): δ = 156,6 (C_{quart}, C_{quart}CHN), 140,5 (C_{quart}, 2 C, C_{quart}C_{quart}N), 138,1 (C_{quart}, C_{quart}N), 135,7 (C_{quart}, C_{quart}N), 128,3 (+, 2 C, C_{Ar}), 126,2 (+, 2 C, C_{Ar}), 123,6 (C_{quart}, 2 C, C_{quart}C_{quart}N), 122,1 (+, 2 C, C_{Ar}), 120,5 (+, 2 C, C_{Ar}), 120,4 (+, 2 C, C_{Ar}), 117,6 (+, C_{Ar}), 109,5 (+, 2 C, C_{Ar}), 68,8 (C_{quart}, C_{quart}OH), 30,5 (+, 2 C, CH₃) ppm. - IR (ATR): v = 3269 (w), 2972 (w), 1625 (w), 1599 (w), 1518 (m), 1478 (m), 1451 (m), 1361 (m), 1334 (w), 1315 (m), 1233 (m), 1204 (w), 1174 (m), 1146 (m), 1117 (w), 1102 (w), 1047 (m), 990 (w), 962 (m), 930 (w), 917 (w), 859 (w), 837 (m), 804 (m), 747 (s), 723 (s), 670 (w), 622 (m), 562 (w), 542 (m), 456 (w), 428 (w) cm⁻¹. - MS (70 eV, EI), *m*/*z* (%): 368,1 (44) [M]⁺, 350,1 (18) [M-H₂O]⁺, 340,1 (10) [M-N₂]⁺, 282,1 (26), 241,0 (52), 43,0 (100) [C₃H₇]⁺. - HR-EIMS (C₂₃H₂₀N₄O): ber. 368,1637; gef. 368,1634.
Die Röntgenstruktur von **3** ist in Figur 4 angegeben.

*Carbazolpeptoid* **4:** Zur Synthese wurden 77,0 mg (0,100 mmol, 1,00 Äquiv.) 2-Chlorotritylchloridresin in 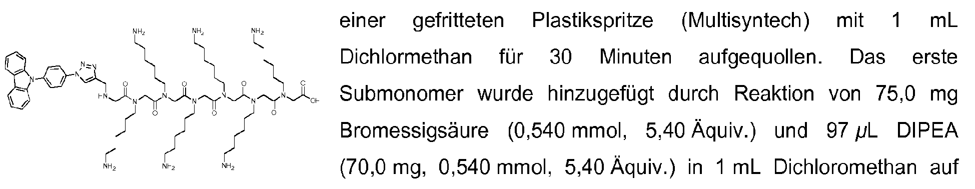 einer gefritteten Plastikspritze (Multisyntech) mit 1 mL Dichlormethan für 30 Minuten aufgequollen. Das erste Submonomer wurde hinzugefügt durch Reaktion von 75,0 mg Bromessigsäure (0,540 mmol, 5,40 Äquiv.) und 97 *µ*L DIPEA (70,0 mg, 0,540 mmol, 5,40 Äquiv.) in 1 mL Dichloromethan auf einer Rüttelplatte für 40 Minuten bei Raumtemperatur, gefolgt von Waschen mit Dichloromethan (2 mL) und *N,N*-Dimethylacetamid (DMA, fünfmal mit 2 mL). Das bromoacetylierte Harz wurde mit 2 M *tert-*butyl(6-aminohexyl)carbamatlösung (0.400 mL, 0.800 mmol, 8.00 equiv.) in DMA auf einer Rüttelplatte bei Raumtemperatur inkubiert, gefolgt von Waschen mit DMA (dreimal 2 mL). Die Reaktionszeit für den Austausch betrug 30 Minuten für *tert*-Butyl(6-aminohexyl)carbamat. Die folgenden Bromoacetylierungen wurde durch 30 minütige Reaktion des Resins mit 1.2 M Bromoessigsäurelösung (0,660 mL, 1,03 mmol, 7,92 Äquiv.) in DMA und 122 µL DIC (100 mg, 0,790 mmol, 7,90 equiv.) ausgeführt. Kupplungsschritte wurden fortgeführt, bis dass die gewünschte Peptoidlänge erzielt war. Für die letzte Austauschreaktion wurde das Resin mit 2 M Propargylaminlösung (0.,400 mL, 0,800 mmol, 8,00 Äquiv.) in DMA auf einer Rüttelplatte bei Raumtemperatur für 30 Minuten inkubiert. Nach dem letzten Schritt wurde das Resin mit DMA (viermal mit 2 mL) und mit Dichlormethan (zweimal mit 1,5 mL) gewaschen. Einige Beads wurden vom Resin für eine Testspaltung entnommen und mit Trifluoroessigsäure (TFA) in einem Eppendorfröhrchen bedeckt. - MS (MALDI-TOF, C₅₃H₁₀₃N₁₃O₈): ber.: 1049,8 g/mol; gef.: 1050,8 [(M+H)] ⁺.

Für die Reaktion mit dem Azidocarbazol **1** wurde das Resin in trockenem THF aufgequollen und 23 mg Cu(CH₃CN)₄PF₆ (61,0 µmol, 0,610 Äquiv.) wurde direkt in die das Harz enthaltende Plastikspritze eingewogen. In 2 mL trockenem THF wurden 34 mg des Azidocarbazols **1** (0,120 mmol, 1,20 Äquiv.) und 33 µL 2,6-Lutidine (30,0 mg, 0,278 mmol, 2,78 Äquiv.) gelöst und zu dem Resin hinzugefügt. Das Resin wurde für 18 h bei Raumtemperatur geschüttelt.

Nach der Reaktion wurde das Harz mit *N*,*N*-Dimethylacetamid (DMA) and Dichloromethan (DCM) gewaschen (dreimal mit je 2 mL).

Das Peptoid wurde vom Harz abgespalten durch Verwendung von 2,00 mL 50% Trifluoroessigsäure (TFA) in Dichloromethan (v/v) für 18 h bei Raumtemperatur. Nach Sammeln der Abspaltungslösung wurde das Harz mit Methanol gewaschen (fünfmal mit 3 mL). Die Elutions- und die Waschlösungen wurden zusammengegeben. Das Lösungsmittel wurde unter vermindertem Druck entfernt, gefolgt von HPLC Aufreinigung des Rohproduktes und nachfolgender Lyophilisierung. Nach Abspaltung, HPLC Aufreinigung und Lyophilisierung wurde die Verbindung **4** als weißer Feststoff in 0,4 %iger Ausbeute erhalten. (0,5 mg, 0,370 µmol) - MS (MALDI-TOF, C₇₁H₁₁₅N₁₇O₈): ber.: 1333,9; gef.: 1334,9 [(M+H)]⁺.

Reaktion von N-4-Azidophenyl)carbazol 1 mit Cyclooctinen

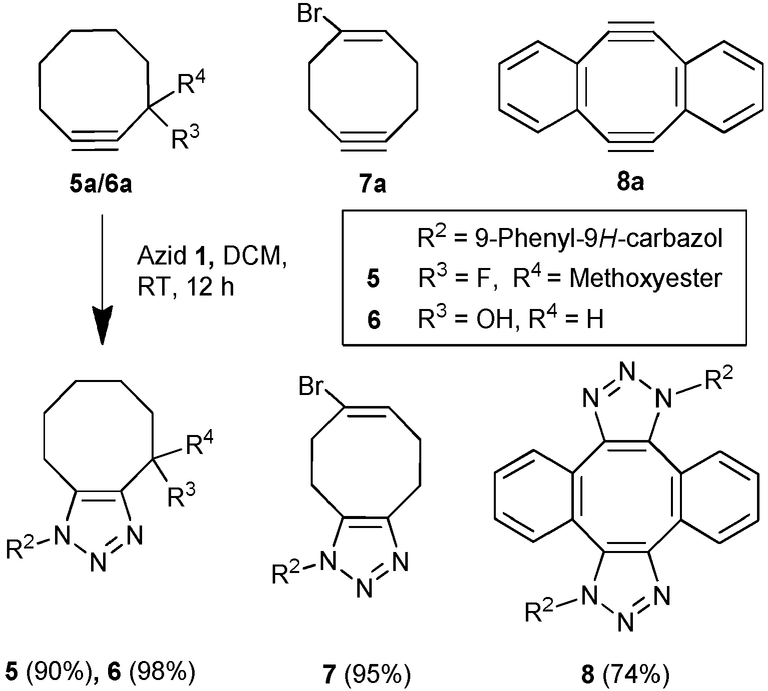

*Methyl 1-(4-(9H-carbazol-9-yl)phenyl)-9-fluoro-4,5,6,7,8,9-hexahydro-1H-cycloocta[d][1,2, 3]triazol-9-carboxylat und Methyl-1-(4-(9H-carbazol-9-yl)phenyl)-4-fluoro-4,5,6,7,8,9-hexahydro-1H-cycloocta[d][1,2,3]triazol-4-carboxylat* **5:** 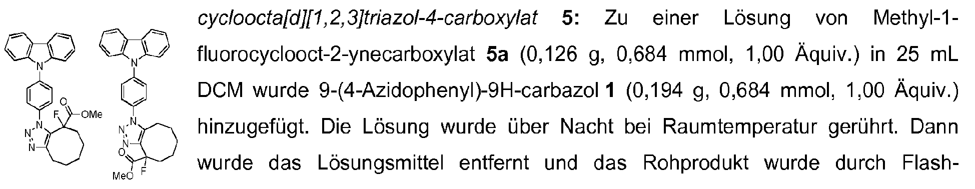 Zu einer Lösung von Methyl-1-fluorocyclooct-2-ynecarboxylat **5a** (0,126 g, 0,684 mmol, 1,00 Äquiv.) in 25 mL DCM wurde 9-(4-Azidophenyl)-9H-carbazol **1** (0,194 g, 0,684 mmol, 1,00 Äquiv.) hinzugefügt. Die Lösung wurde über Nacht bei Raumtemperatur gerührt. Dann wurde das Lösungsmittel entfernt und das Rohprodukt wurde durch Flash-Säulenchromatographie aufgereinigt (Kieselgel, Eluent: Cyclohexan/Ethylacetat 50:1-3:1) um einen weißen Feststoff in 90 %iger Ausbeute hervorzubringen (0,222 g, 0,474 mmol). 0.043 g Carbazolreaktand wurden reisoliert. Mischung von Isomeren: : - R_{f} = 0,36 (3:1 CH/EE). - mp = 92,9 °C. - ¹H-NMR (400 MHz, CDCl₃): δ = 8,20-8.14 (m, 1,99 H, Ar-H), 7,83-7,76 (m, 1,53 H, Ar-H), 7,75-7,60 (m, 0,98 H, Ar-H), 7,69-7,63 (m, 1,56 H, Ar-H), 7,52 - 7,41 (m, 4,07 H, Ar-H), 7,37 - 7,30 (m, 2,00 H, Ar-H), 3,93 (s, 2,32 H, CH₃ (major isomer)), 3,48 (s, 0,73 H, CH₃ (minor isomer)), 3,43-3,31 (m, 0,24 H, CH₂), 3,24-3,08 (m, 1,02 H, CH₂), 3,07-2,94 (m, 0,79 H, CH₂), 2,69-2,47 (m, 2,04 H, CH₂), 2,09-1,92 (m, 1,03 H, CH₂), 1,92-1,70 (m, 3,81 H, CH₂), 1,70-1,53 (m, 2,14 H, CH₂) ppm. - ¹³C-NMR (100 MHz, CDCl₃): δ = 170,5 (C_{quart}, d, *²J_{C-F}* = 27,3 Hz, C=O), 169,1 (C_{quart}, d, *²J_{C-F}* = 28,6 Hz, C=O), 142,8 (C_{quart}, C_{Ar}), 142,5 (C_{quart}, C_{Ar}), 140,4 (C_{quart}, C_{Ar}), 140,3 (C_{quart}, C_{Ar}), 139,6 (C_{quart}, C_{Ar}), 139,4 (C_{quart}, C_{Ar}), 135,4 (C_{quart}, d, *³J_{C-F}* = 2,7 Hz, C_{Ar}), 134,6 (C_{quart}, C_{Ar}), 134,2 (C_{quart}, C_{Ar}), 128,8 (+,C_{Ar}), 128,8 (+, C_{Ar}), 127,9 (+, C_{Ar}), 127,3 (+, C_{Ar}), 127,2 (+, C_{Ar}), 126,3 (+, C_{Ar}), 126,2 (+, C_{Ar}), 123,7 (C_{quart}, C_{Ar}), 123,7 (C_{quart}, C_{Ar}), 120,6 (+, C_{Ar}), 120,5 (+, C_{Ar}), 120,5 (+, C_{Ar}), 120,5 (+, C_{Ar}), 109,5 (+, C_{Ar}), 109,5 (+, C_{Ar}), 92,2 (C_{quart}, d, *¹J_{C-F}* = 187,0 Hz, C-F), 53,1 (+, CH₃), 52,9 (+, CH₃), 34,2 (-, d, *²J_{C-F}* = 23.4 Hz, CH₂), 33,8 (-, d, *²J_{C-F}* = 23,4 Hz, CH₂), 26,7 (-, d, *⁴J_{C-F}* = 0,8 Hz, CH₂), 25,8 (-, d, *⁴J_{C-F}* = 1,5 Hz, CH₂), 25,4 (-, CH_{2,}), 23,7 (-, CH₂), 22,7 (-, d, *³J_{C-F}* = 6,6 Hz, CH₂), 22,4 (-,CH₂), 21,8 (-, d, *³J_{C-F}* = 4,1 Hz, CH₂), 21,5 (-, CH₂) ppm. - ¹⁹F-NMR (376 MHz, CDCl₃): δ = -146,8 ppm. - IR (ATR): v = 3058 (w), 2928 (w), 2857 (w), 1759 (m), 1600 (w), 1518 (s), 1479 (w), 1450 (s) cm⁻¹. - MS (70 eV, EI), *m*/*z* (%): 468 [M]⁺ (77), 440 [M-N₂]⁺ (57), 381 [C₂₆H₂₂FN₂]⁺ (100), 242 [C₁₈H₁₂N]⁺ (34). - HR-EIMS ber. C₂₈H₂₅FN₄O₂: 468,1962; gef. 468,1962.

*1-(4-(9H-Carbazol-9-yl)phenyl)-4,5,6,7,8,9-hexahydro-1H-cycloocta[d][1,2,3]triazol-9-ol* **6** (Isomer 1) *und* 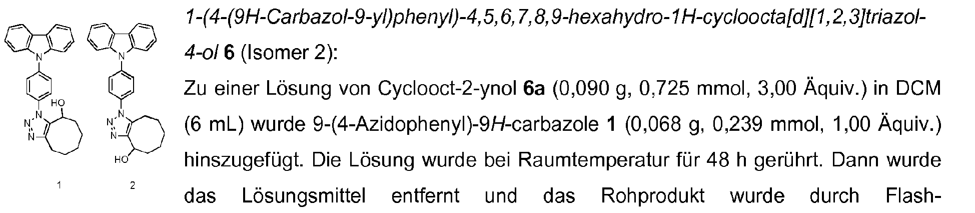 *1-(4-(9H-Carbazol-9-yl)phenyl)-4,5,6,7,8,9-hexahydro-1H-cycloocta[d][1,2,3]triazol-4-ol* **6** (Isomer 2):
Zu einer Lösung von Cyclooct-2-ynol **6a** (0,090 g, 0,725 mmol, 3,00 Äquiv.) in DCM (6 mL) wurde 9-(4-Azidophenyl)-9*H*-carbazole **1** (0,068 g, 0,239 mmol, 1,00 Äquiv.) hinszugefügt. Die Lösung wurde bei Raumtemperatur für 48 h gerührt. Dann wurde das Lösungsmittel entfernt und das Rohprodukt wurde durch Flash-Säulenchromatographie aufgereinigt (Kieselgel, Eluent: Cyclohexan/Ethylacetat 3:1) um Isomer 1 in 35 %iger (0,029 g, 0,071mmol) und Isomer 2 in 63 %iger Ausbeute (0,052 g, 0,127 mmol) beide als hellgelbe Feststoffe hervorzubringen. (0.010 mg des Carbazolreaktanden konnten reisoliert werden). Isomer 2 wurde komplett aufgereinigt und charakterisiert:
- R_{f} = 0,29 (3:1 CH/EE). - mp = 195,3 °C. - ¹H-NMR (400 MHz, CDCl₃): δ = 8,20-8,14 (m, 2H, Ar-H), 7,80-7,75 (m, 2H, Ar-H), 7,70-7,65 (m, 2H, Ar-H), 7,51-7,42 (m, 4H, Ar-H), 7,37-7,29 (m, 2H, Ar-H), 5,23 (dd, 1H, *³J_{H-H}* = 9,2 Hz, 4,2 Hz, CH-O), 3,33 (bs, 1H, OH), 3,14-3,03 (m, 1H, CH₂), 2,94-2,84 (m, 1H, CH₂), 2,26-2,15 (m, 1H, CH₂), 2,14-2,04 (m, 1H, CH₂), 1,83 (q, 2H, *³J_{H-H}* = 6,3 Hz, CH₂), 1,72 (q, 2H, *³J_{H-H}* = 6,0 Hz, CH₂), 1,67-1,59 (m, 1H, CH₂), 1,56-1,43 (m, 1H, CH₂) ppm. - ¹³C-NMR (100 MHz, CDCl₃): δ = 147,5 (C_{quart}), 140,4 (C_{quart}), 139,1 (C_{quart}), 134,7 (C_{quart}), 133,0 (C_{quart}), 127,8 (+, CH), 127,0 (+, CH), 126,2 (+, CH), 123,7 (C_{quart}), 120,5 (+, CH), 120,5 (+, CH), 109,5 (+, CH), 66,9 (+, CH), 35,9 (-, CH₂), 27,2 (-, CH₂), 25,0 (-, CH₂), 22,3 (-, CH₂), 21,4 (-, CH₂) ppm. - IR (ATR): v = 3246 (w), 3067 (w), 2935 (w), 2851 (w), 1599 (w), 1514 (m), 1480 (w), 1450 (m) cm⁻¹. - MS (70 eV, EI), *m*/*z* (%): 408 [M]⁺ (23), 380 [(M-N₂)]⁺ (20), 43 (100). - HR-EIMS: ber. C₂₆H₂₄N₄O: 408,1950; gef. 408,1952.

*(E)-9-(4-(6-Bromo-4,5,8,9-tetrahydro-1H-cycloocta[d][1,2,3]triazol-1-yl)phenyl)-9H-carbazol oder (E)-9-(4-(7-Bromo-4,5,8,9-tetrahydro-1H-cycloocta[d][1,2,3]triazol-1-yl)phenyl)-9H-carbazol **7:*** 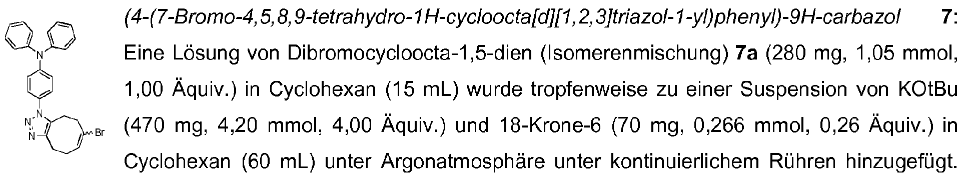 Eine Lösung von Dibromocycloocta-1,5-dien (Isomerenmischung) **7a** (280 mg, 1,05 mmol, 1,00 Äquiv.) in Cyclohexan (15 mL) wurde tropfenweise zu einer Suspension von KOtBu (470 mg, 4,20 mmol, 4,00 Äquiv.) und 18-Krone-6 (70 mg, 0,266 mmol, 0,26 Äquiv.) in Cyclohexan (60 mL) unter Argonatmosphäre unter kontinuierlichem Rühren hinzugefügt. Rühren wurde für 110 Minuten fortgeführt (bis das Ausgangsmaterial verbraucht war). Dann wurde die Reaktion durch Zugabe einer gesättigten wässrigen Lösung von NH₄Cl (15 mL) und Wasser (15 mL) gequencht. Die zwei Phasen wurden getrennt und die wässrige Phase wurde mit Ethylacetat extrahiert (3x15 mL). Das Azid **1** (100 mg, 0,35 mmol, 0,33 Äquiv.) wurde zu den kombinierten organischen Phasen hinzugefügt und die resultierende Lösung wurde über Nacht gerührt. Das Lösungsmittel wurde an einem Rotationsverdampfer entfernt und das Rohprodukt wurde durch Flash-Säulenchromatographie aufgereinigt (Kieselgel, Eluent: Cyclohexan/Ethylacetat 4:1) um zwei Isomere (0,080 g, 0,170 mmol (49%) und 0,076 g, 0,162 mmol (46%)) als hellgelbe Feststoffe hervorzubringen.

Charakterisierung des zuerst isolierten Isomers: - R_{f} = 0,18 (4:1 CH/EE). - mp = 181 °C. - ¹H-NMR (400 MHz, CDCl₃): δ = 8,16 (d, 2H, *³J_{H-H}* = 7.7 Hz, Ar-H), 7,79-7,75 (m, 2H, Ar-H), 7,72-7,67 (m, 2H, Ar-H), 7,49-7,42 (m, 4H, Ar-H), 7,36-7,31 (m, 2H, Ar-H), 6,12 (dd, 1H, *³J_{H-H}* = 8.4 Hz, CH=CBr), 3,36-3,28 (m, 2H, CH₂), 3,12-3,04 (m, 2H, CH₂), 3,02-2,93 (m, 2H, CH₂), 2,74-2,63 (m, 2H, CH₂) ppm. - ¹³C-NMR (100 MHz, CDCl₃): δ = 143,9 (C_{quart}, C_{Ar}), 140,4 (C_{quart}, C_{Ar}), 139,0 (C_{quart}, C_{Ar}), 135,1 (C_{quart}, C_{Ar}), 132,9 (C_{quart}, C_{Ar}), 128,8 (+, CH), 127,8 (+, CH), 126,9 (+, CH) 126,9 (C_{quart}, CBr), 126,2 (+, CH), 123,7 (C_{quart}, C_{Ar}), 120,5 (+, CH), 120,5 (+, CH), 109,6 (+, CH), 39,4 (-, CH₂), 25,4 (-, CH₂), 25,1 (-, CH₂), 24,1 (-, CH₂) ppm. - IR (ATR): v = 3055 (w), 2917 (w), 2848 (w), 1720 (w), 1599 (w), 1517 (s), 1478 (w), 1449 (s) cm⁻¹. - MS (70 eV, EI), *m*/*z* (%): 468/470 [M]⁺ (11/11), 361 [(M-Br-N₂)]⁺ (36), 241 (100), 166 [(C₁₂H₈N)]⁺ (80). - HR-EIMS: ber. C₂₆H₂₈BrN₄: 470,0929; gef. 470,0928.

*1,8-bis(4-(9H-Carbazol-9-yl)phenyl)-1,8-dihydrodibenzo[3,4:7,8]cycloocta[1,2-d:5,6-']bis([1,2,3]triazol) und 1*,*10-bis(4-(9H-Carbazol-9-yl)phenyl)-1,10-dihydrodibenzo[3,4:7,8]cycloocta[1,2-d:5,6-d']bis-([1,2,3]triazol)* **8**: 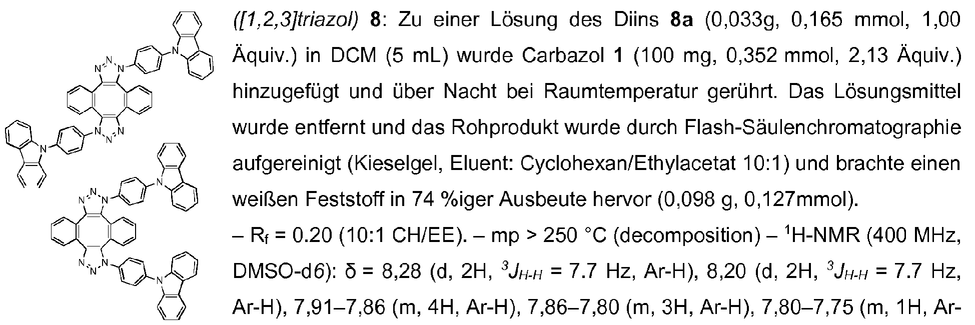 Zu einer Lösung des Diins **8a** (0,033g, 0,165 mmol, 1,00 Äquiv.) in DCM (5 mL) wurde Carbazol **1** (100 mg, 0,352 mmol, 2,13 Äquiv.) hinzugefügt und über Nacht bei Raumtemperatur gerührt. Das Lösungsmittel wurde entfernt und das Rohprodukt wurde durch Flash-Säulenchromatographie aufgereinigt (Kieselgel, Eluent: Cyclohexan/Ethylacetat 10:1) und brachte einen weißen Feststoff in 74 %iger Ausbeute hervor (0,098 g, 0,127mmol). - R_{f} = 0.20 (10:1 CH/EE). - mp > 250 °C (decomposition) - ¹H-NMR (400 MHz, DMSO-d*6*): δ = 8,28 (d, 2H, *³J_{H-H}* = 7.7 Hz, Ar-H), 8,20 (d, 2H, *³J_{H-H}* = 7.7 Hz, Ar-H), 7,91-7,86 (m, 4H, Ar-H), 7,86-7,80 (m, 3H, Ar-H), 7,80-7,75 (m, 1H, Ar-H), 7,71-7,63 (m, 2H, Ar-H), 7,59 (d, 2H, *³J_{H-H}* = 8,7 Hz, Ar-H), 7,52-7,44 (m, 3H, Ar-H), 7,43-7,38 (m, 3H, Ar-H), 7,37-7,30 (m, 6H, Ar-H), 7,28-7,20 (m, 4H, Ar-H) ppm. - ¹³C-NMR (100 MHz, DMSO- d*6*), δ = 145,1 (C_{quart}, C_{Ar}), 145,1 (C_{quart}, C_{Ar}), 139,7 (C_{quart}, C_{Ar}), 139,6 (C_{quart}, C_{Ar}), 137,7 (C_{quart}, C_{Ar}), 137,5 (C_{quart}, C_{Ar}), 134,6 (C_{quart}, C_{Ar}), 134,2 (C_{quart}, C_{Ar}), 134,1 (C_{quart}, C_{Ar}), 131,7 (+,C_{Ar}), 131,3 (C_{quart}, C_{Ar}), 131,2 (+,C_{Ar}), 131,0 (+,C_{Ar}), 130,7 (+,C_{Ar}), 130,5 (+,C_{Ar}), 130,2 (C_{quart}, C_{Ar}), 130,0 (+,C_{Ar}), 129,4 (+,C_{Ar}), 129,3 (C_{quart}, C_{Ar}), 129,3 (+,C_{Ar}), 127,8 (+,C_{Ar}), 127,8 (+,C_{Ar}), 127,6 (+,C_{Ar}), 127,4 (C_{quart}, C_{Ar}), 126,8 (+,C_{Ar}), 126,4 (+,C_{Ar}), 126,3 (+,C_{Ar}), 126,1 (C_{quart}, C_{Ar}), 122,9 (C_{quart}, C_{Ar}), 122,8 (C_{quart}, C_{Ar}), 120,6 (+,C_{Ar}), 120,5 (+,C_{Ar}), 120,4 (+,C_{Ar}), 120,3 (+,C_{Ar}), 109,5 (+,C_{Ar}), 109,5 (+,C_{Ar}) ppm. - IR (ATR): v = 3054 (w), 2922 (w), 2848 (w), 1598 (w), 1517 (m), 1478 (w), 1449 (m), 1352 (w), 1334 (w), 1314 (w), 1227 (m) cm⁻¹. - MS (EI, 3-NBA), *m*/*z*: 769 [M+H]⁺. - HR-FABMS: ber. [M+H]⁺ C₅₂H₃₃N₈: 769,2828; gef. 769,2830.

Die Ergebnisse von UVVIS-Messungen in Lösung (siehe auch Tabelle 1) beweisen, dass die gewünschte Verdrillung der pi-Systeme nicht nur in Kristallen, sondern auch in Lösung und im amorphen Festkörper auftritt. Die Absorptionsspektren stellen somit die Superposition der Absorptionsspektren der isolierten pi-Systeme dar. Weitere Banden zwischen 300 und 350 nm treten aufgrund von Charge-Transfer-Übergängen auf, die zur Emission von sichtbarem Licht führen. Außerdem finden sich in der Tabelle Daten zur Emissionsfarbe der Verbindungen, die bei den gezeigten Beispielen im blauen Spektralbereich liegt.

| **Tabelle 1:** Spektroskopische Daten einiger erfindungsgemäßer Verbindungen bei Raumtemperatur. | | | | | |
|---|---|---|---|---|---|
| | λ_{abs}(nm) | ε (M⁻¹ cm⁻¹) | λₑₘ (nm) | Φ | Stokes shift (nm) |
| **1^{b}** | 293 | 21300 ± 600 | | | |
| **2^{b}** | 292 | 15700 ± 500 | 387 | 0.72 ± 0.051 | 95 |
| **3^{a}** | 292 | | 492 | 0.41 ± 0.03 | 200 |
| **3^{b}** | 292 | 15700 ± 500 | 384 | 0.365 ± 0.030 | 92 |
| **3^{c}** | 292 | 23500 ± 800 | 362 | 0.468 ± 0.046 | 70 |
| **3^{e}** | 291 | 19800 ± 700 | 424 | | 132 |
| **4^{a}** | 291 | | 434 | | 143 |
| **4^{d}** | 291 | 4000 ± 200 | 467 | 0.027 ± 0.001 | 176 |
| **4^{e}** | 291 | 3800 ± 250 | 431 | 0.102 ± 0.005 | 140 |
| **5^{a}** | 293 | | 415 | | 122 |
| **5^{b}** | 293 | 1950 ± 50 | 342/356 | 0.311 ± 0.081 | 49/63 |
| **6^{a}** | 293 | | 490 | | 197 |
| **6^{b}** | 293 | 19600 ± 900 | 345/360 | 0.319 ± 0.040 | 52/67 |
| **7^{a}** | 293 | | 492 | | 199 |
| **7^{b}** | 293 | 12400 ± 300 | 345/360 | 0.284 ± 0.058 | 52/67 |
| **7^{c}** | 291 | 32000 ± 7000 | 345/362 | 0.137 ± 0.036 | 54/71 |
| **7^{e}** | 291 | 11100 ± 1000 | 431 | 0.347 ± 0.049 | 140 |
| **7^{g}** | 292 | | 341/357 | | 49/65 |
| **7^{h}** | 291 | | 342/357 | | 51/66 |
| **7ⁱ** | 291 | | 344/360 | | 53/69 |
| **7^{j}** | 291 | | 345/362 | | 54/71 |
| **8^{a}** | 293 | | 416 | | 123 |
| **8^{f}** | 293 | 28000 ± 3000 | 459 | 0.552 ± 0.078 | 166 |
| ^{a} Feststoff, ^{b} DCM, ^{c} DMF, ^{d} H₂O, ^{e} MeOH, ^{f} DMSO, ^{g} Cyclohexan, ^{h} Diethylether, ⁱ Ethylacetat, ^{j} DMF | | | | | |

Durch quantenchemische Rechnungen (DFT, B3-LYP/def2-TZVP Level) (S. Fery-Forgues and D. Lavabre, J. Chem. Educ., 1999, 76, 1260-1264) konnten die Grenzorbitale visualisiert werden, wie in Figuren 5 bis 7 dargestellt ist. Wie gewünscht liegt das HOMO auf der elektronenspendenden Donorgruppe, während das LUMO auf der elektronenziehenden Akzeptorgruppe liegt.

**Tabelle 2: B3LYP/def2-TZVP HOMO und LUMO Energien in eV im Grundzustand, links: 2,3,7 Gasphase und rechts: 3 in Dichlormethan und Methanol (COSMO).**

| | **2** | **3** | **7** | | | **3 (CH₂Cl₂)** | **3 (MeOH)** |
|---|---|---|---|---|---|---|---|
| HOMO | -5,72 | -5,71 | -5,76 | | HOMO | -5,70 | -5,70 |
| LUMO | -1,62 | -1,52 | -1,38 | | LUMO | -1,42 | -1,41 |

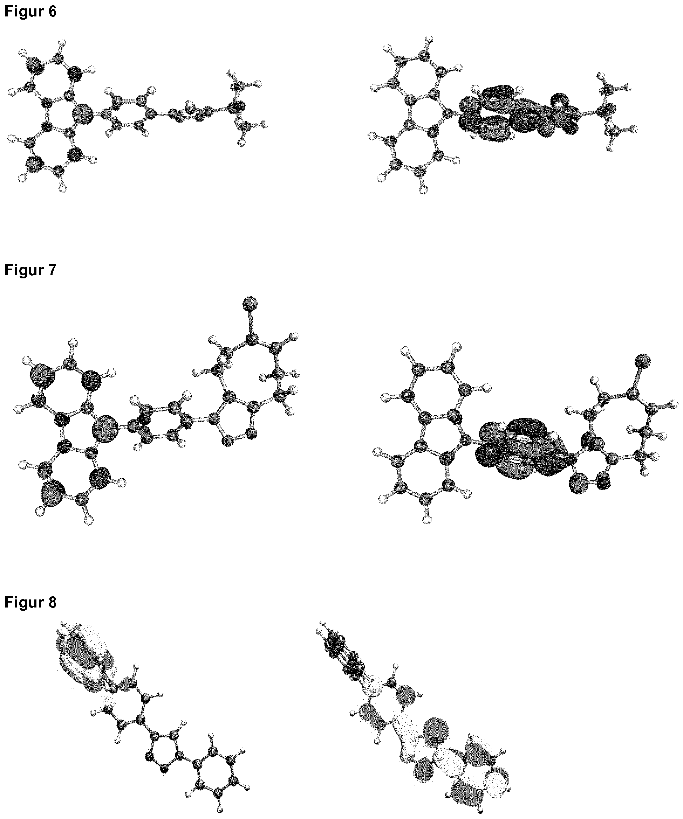

Weitere Beispiele für erfindungsgemäße Verbindungen (om306 bis om308, om311) wurden mit bp86-def2svp und b3lyp-def2svp berechnet und zeigen klar, dass das HOMO auf der elektronenspendenden Donorgruppe liegt, während das LUMO auf der elektronenziehenden Akzeptorgruppe liegt. (siehe Figuren 8 bis 13).

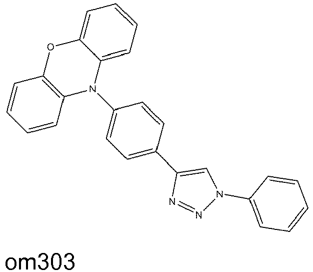

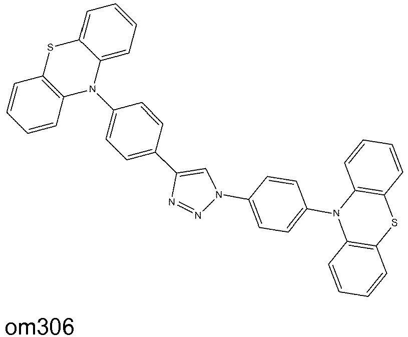

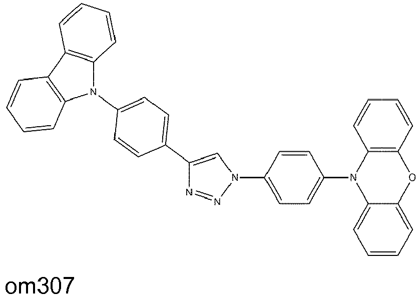

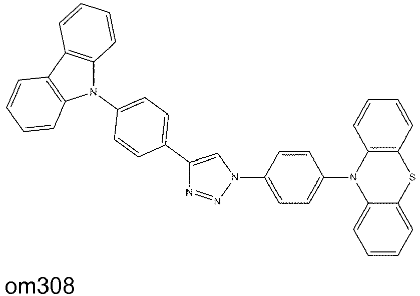

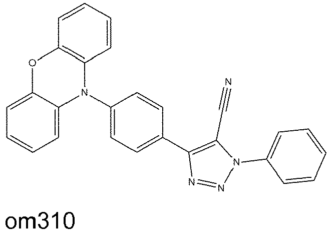

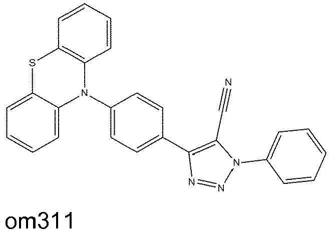

### Synthese und Charakterisierung weiterer Beispiele:

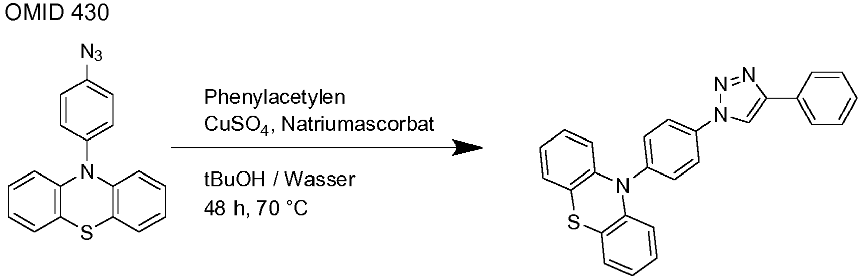

Ausbeute: 69 %
¹H-NMR (300 MHz, CDCl₃):δ= 6.46 (dd, J=7.9 , 1.3 Hz, 2 H), 7.01-6.88 (m, 4 H), 7.13 (dd, J=7.3, 1.7 Hz, 2 H) 7.51 (dd, J=17.7, 8.2 Hz, 4 H), 7.40 (t, J= 7.4 Hz, 1 H), 8.01-7.91 (m, 4 H), 8.25 (s, 1 H)
IR (ATR): *ṽ* (cm⁻¹) = 1571 (w), 1514 (w), 1456 (m), 1443 (m), 1406 (w), 1294 (w), 1258 (w), 1223 (m), 1036 (m), 992 (w), 913 (w), 832 (w), 748 (m), 692 (m), 655 (w), 614 (w), 549 (w), 537 (w), 515 (w), 471 (vw), 436 (w), 387 (vw), 3138 (vw), 3058 (vw)
MS (70 eV, EI) m/z (%)= 418 (72) [M⁺], 390 (100) [M- C₂₆H₁₈N₂S]⁺, 275 (32) [M-C₁₈H₁₂NS], 102 (34) [M-C₈H₆] 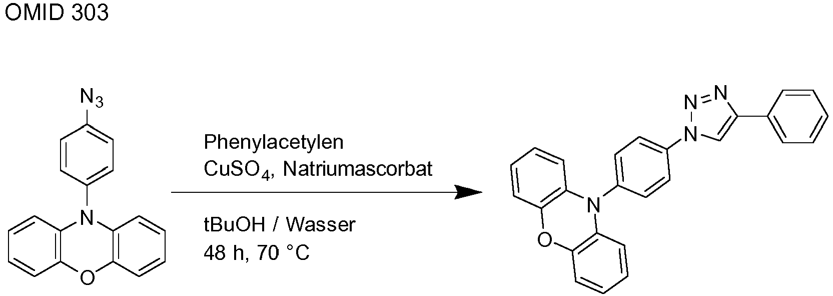 ¹H-NMR (300 MHz, CDCl₃):δ=5.97 (d, 4 H), 6.68 (d, 4 H), 7.47 (ddd, J=40.0, 22.6, 13.9 Hz, 5 H), 7.95 (d, 7.3 Hz, 2 H), 8.06 (d, 8.0 Hz, 2 H), 8.28 (s, 1 H) 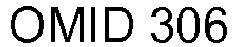 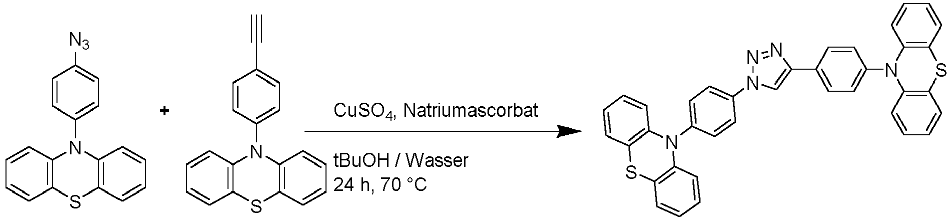 ¹H-NMR (300 MHz, CDCl₃): δ=6.37 (dd, J=7.9, 1.4 Hz, 2 H), 6.50 (dd, J= 7.9, 1.3 Hz, 2 H), 7.03- 6.82 (m, 8 H) 7.07 (dd, 7.2, 1.8 Hz, 2 H), 7.15 (dd, 7.3, 1.8 Hz, 2 H), 7.52 (dd, J= 14.1, 8.6 Hz, 4 H), 7.99 (d, 8.7 Hz, 2 H), 8.14 (d, 8.4 Hz, 2 H), 8.31 (s, 1 H) 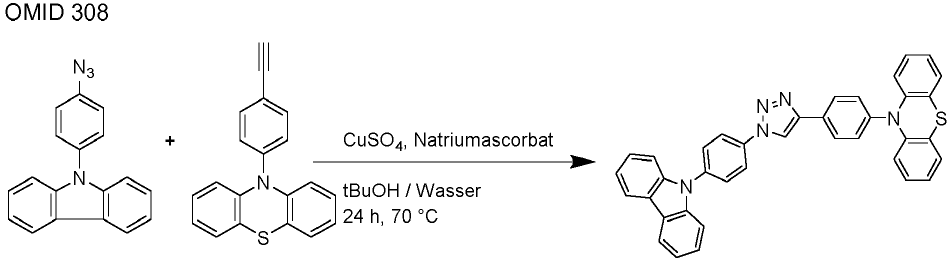 ¹H-NMR (300 MHz, CDCl₃): δ=6.38 (dd, 7.9, 1.3 Hz, 2 H), 6.95- 9.83 (m, 4 H), 7.07 (dd, 7.2, 1.8 Hz, 2 H), 7.34 (ddd, J= 8.0, 5.2, 2.9 Hz, 2 H), 7.49 -7.45 (m, 4 H) 7.51 (d, J= 8.4 Hz, 2H), 7. 81 (d, 8.7 Hz, 2 H), 8.07 (d, 8.7 Hz, 2 H), 8.17 (dd, 8.0, 3.2 Hz, 2 H), 8.37 (s, 1 H) 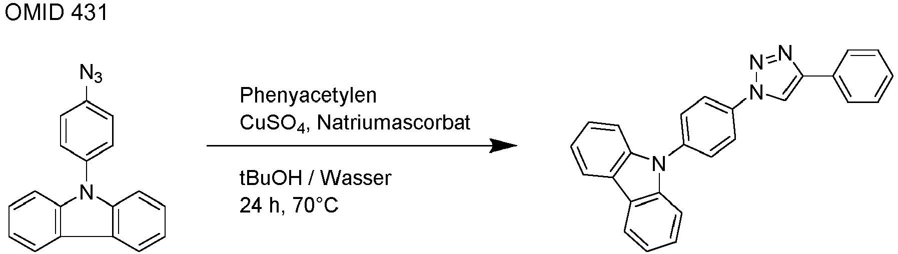 ¹H-NMR (300 MHz, CDCl₃): δ=7.33 (ddd, J=8.0, 4.8, 3.4 Hz, 2 H), 7.53-7.40 (m, 7 H), 7.79 (d, 8.8 Hz, 2 H), 7.96 (d, 7.1 Hz, 2H), 8.06 (d, J=8.8 Hz, 2 H), 8.17 (d, J=7.7 Hz, 2 H), 8.30 (s, 1 H)

**PL-Messungen**

| **Verbindung** | **Lösungsmittel** | **Amax [nm]** | **λExc. (PL) [nm]** | **PLQY [%]** | **λExc. (PLQY) [nm]** |
|---|---|---|---|---|---|
| OMID 430 | CH₂Cl₂ | 508 | 290 | 3 | 290 |
| OMID 303 | CDCl₃ | 483 | 290 | 9 | 290 |
| OMID 306 | CH₂Cl₂ | 515 | 314 | 2.5 | 314 |
| OMID 308 | CH₂Cl₂ | 485 | 290 | 2 | 290 |
| OMID 431 | CH₂Cl₂ | 385 | 290 | 48 | 290 |

| | | | | | |
|---|---|---|---|---|---|
| λmax = Emissionsmaximun, λExc. = Anregungswellenlänge, PLQY = Photolumineszenz-Quantenausbeute | | | | | |

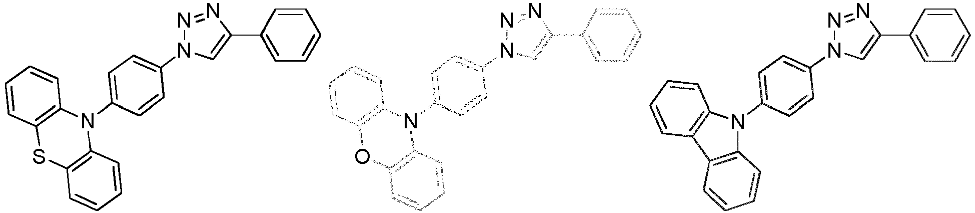

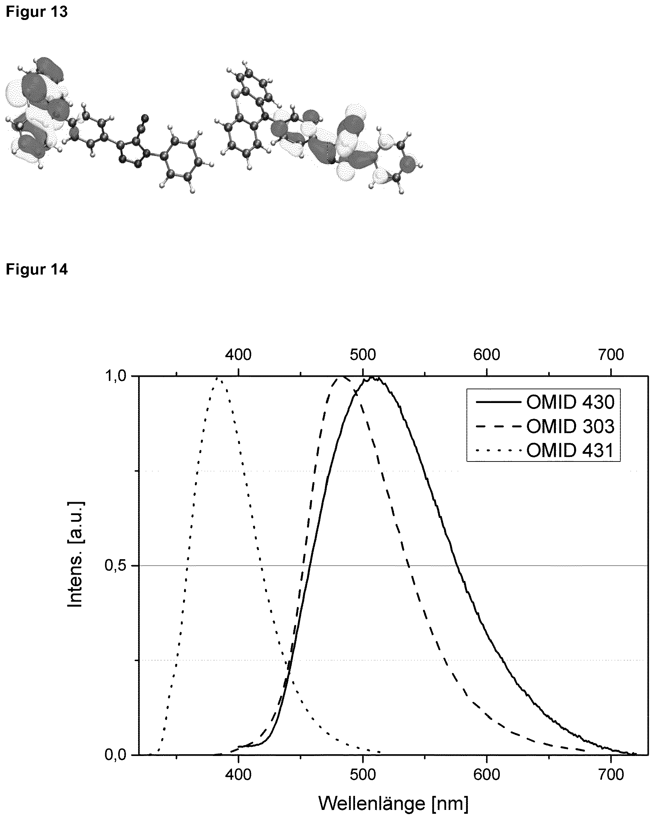

In Figur 14 sind die Photoluminsezenz (PL)-Spektren (Intensität (willkürliche Einheiten, a.u.) über Wellenlänge (nm)) der drei oben gezeigten Verbindungen enthalten (rechte Verbindung, linkes Spektrum; mittlere Verbindung, mittleres Spektrum; linke Verbindung, rechtes Spektrum in Figur 14).

### Weitere Beispiele für erfindungsgemäße Verbindungen:

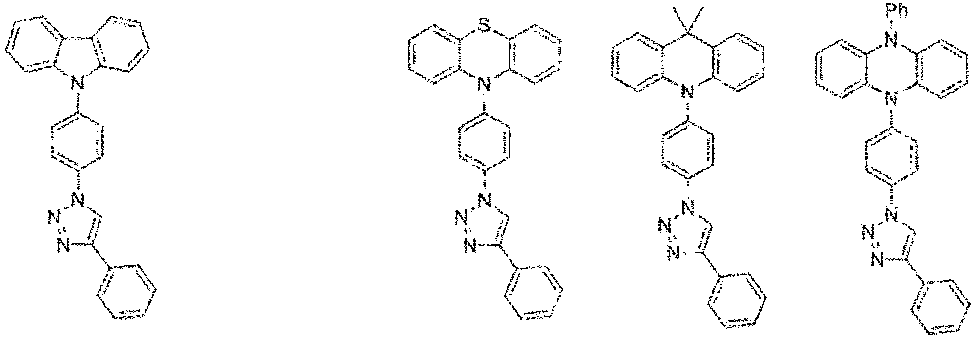

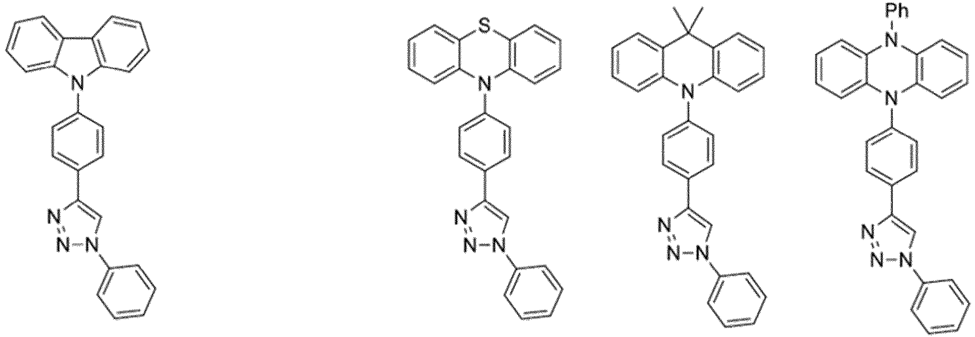

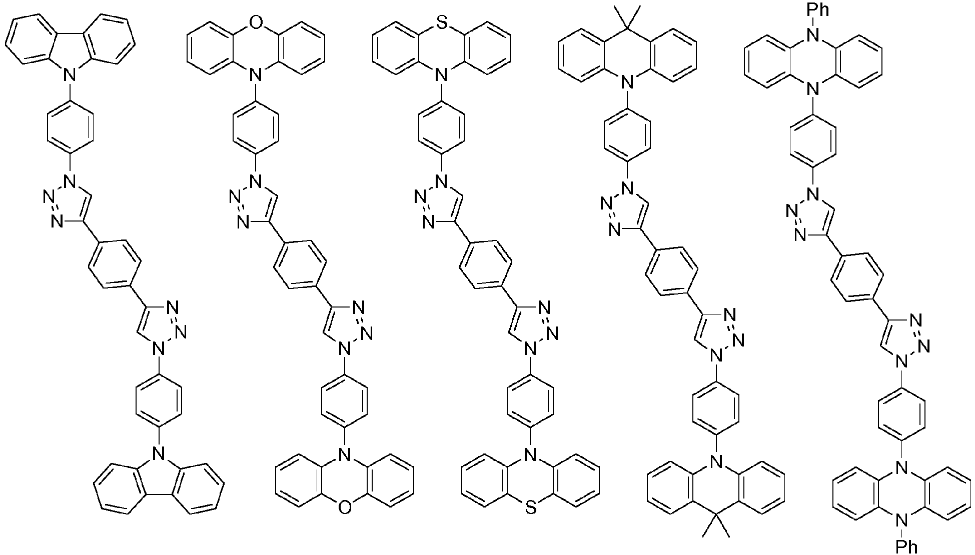

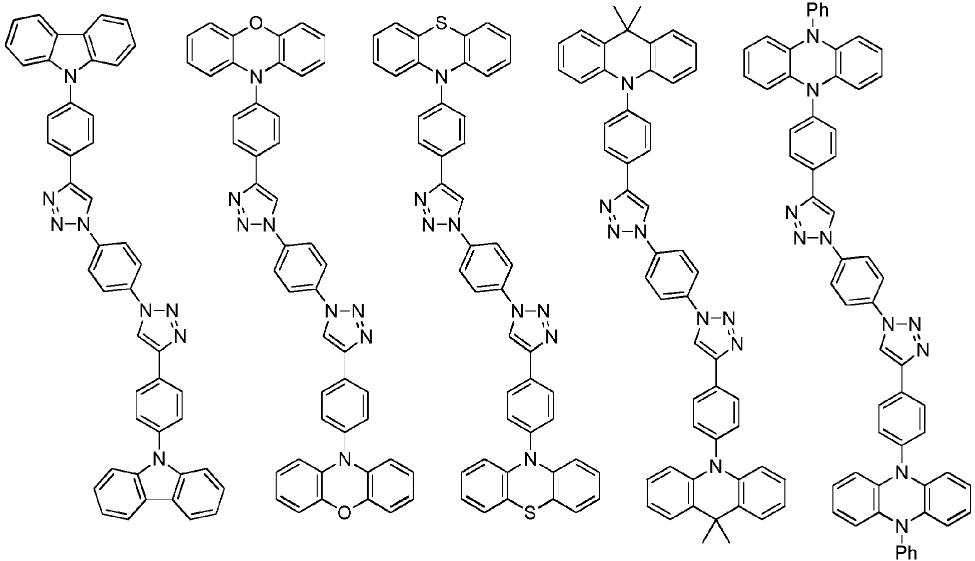

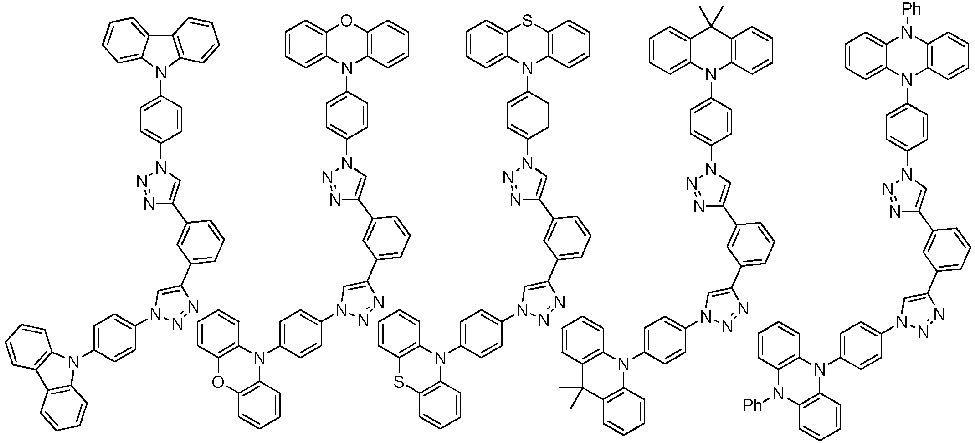

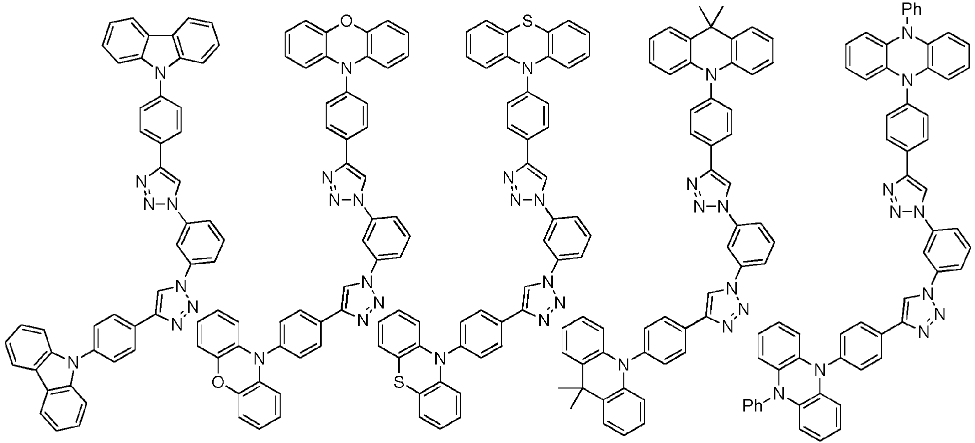

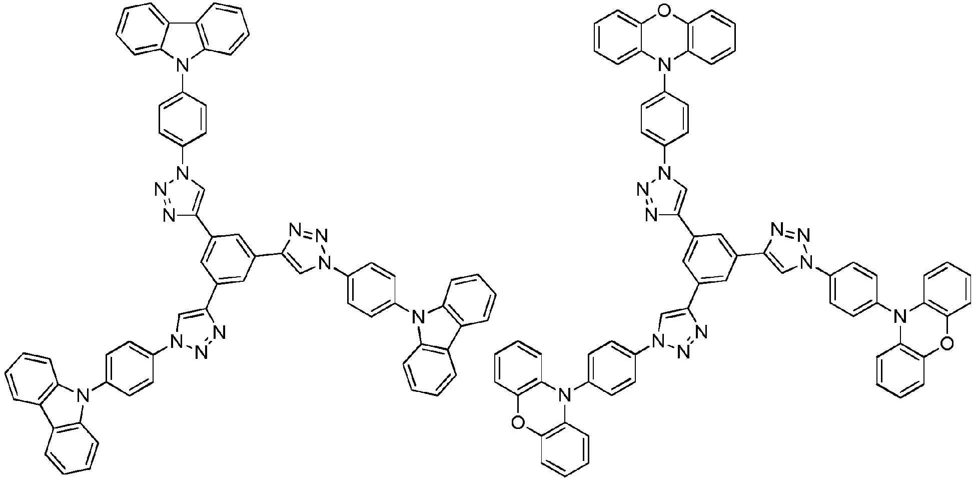

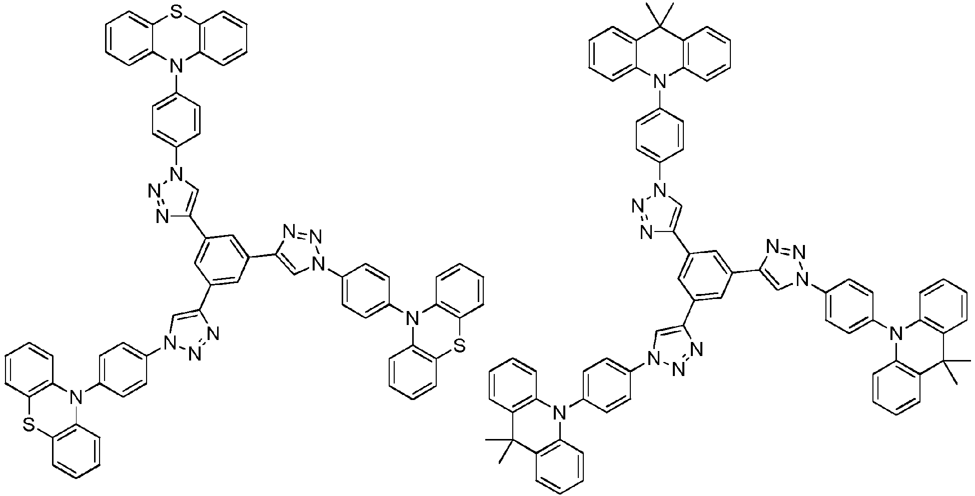

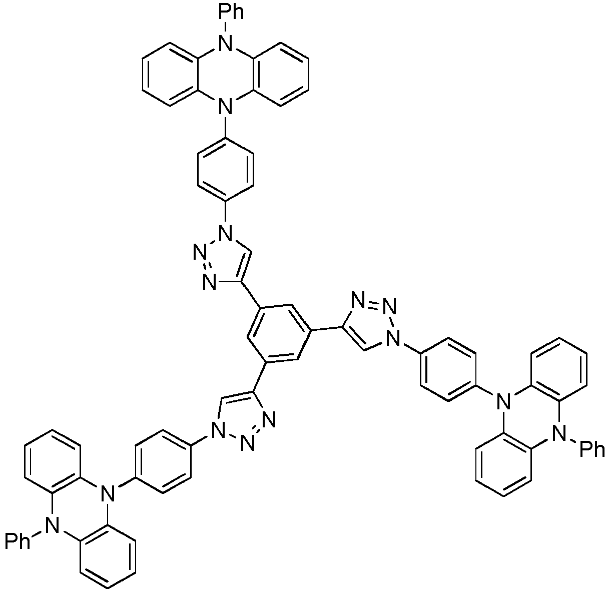

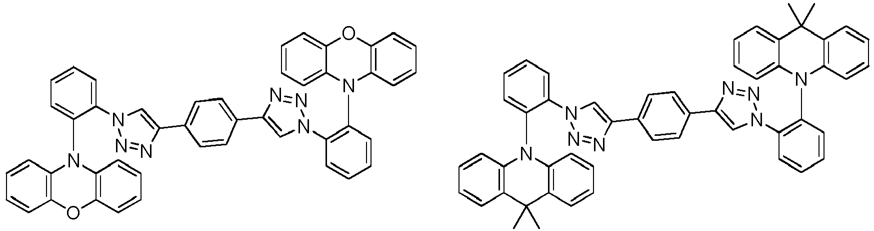

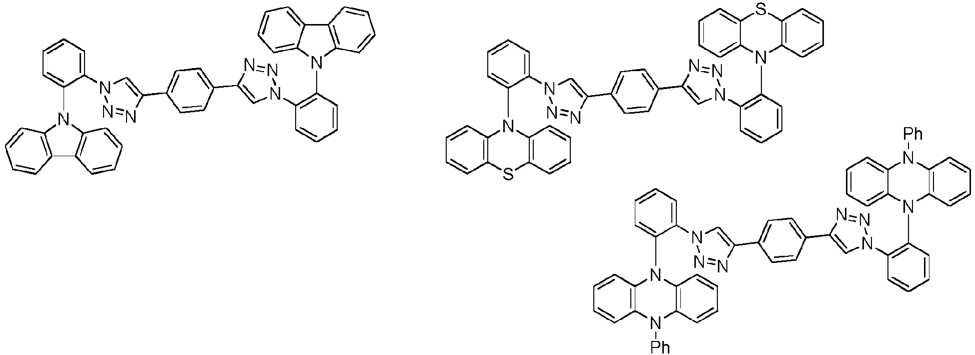

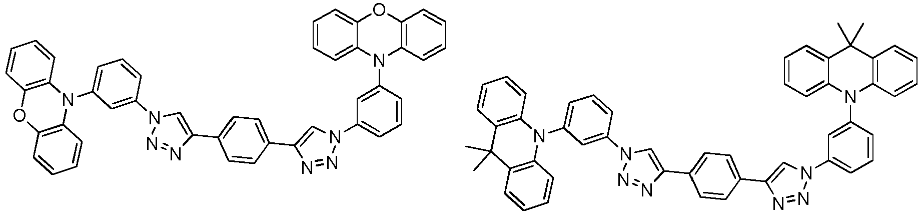

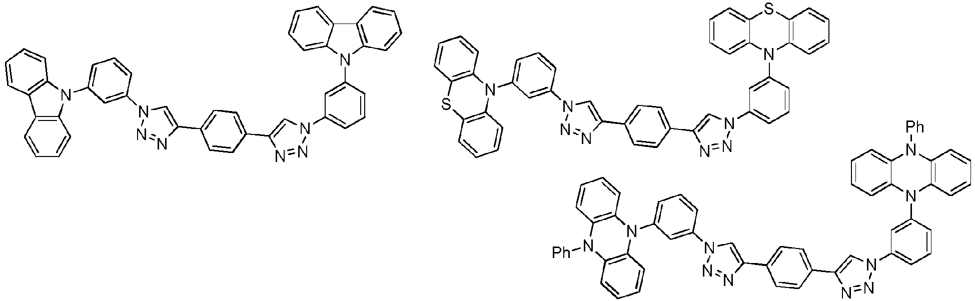

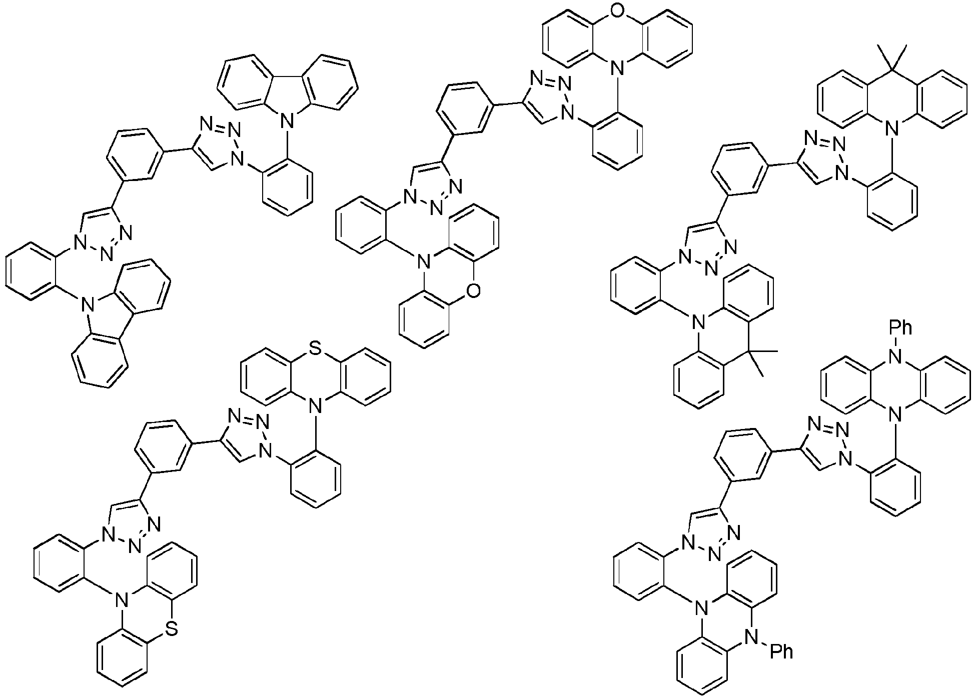

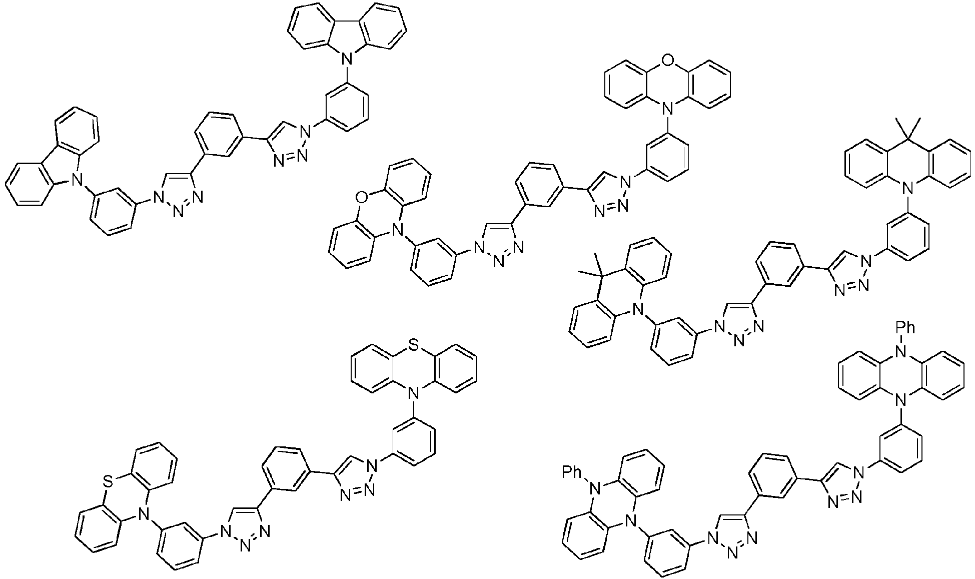

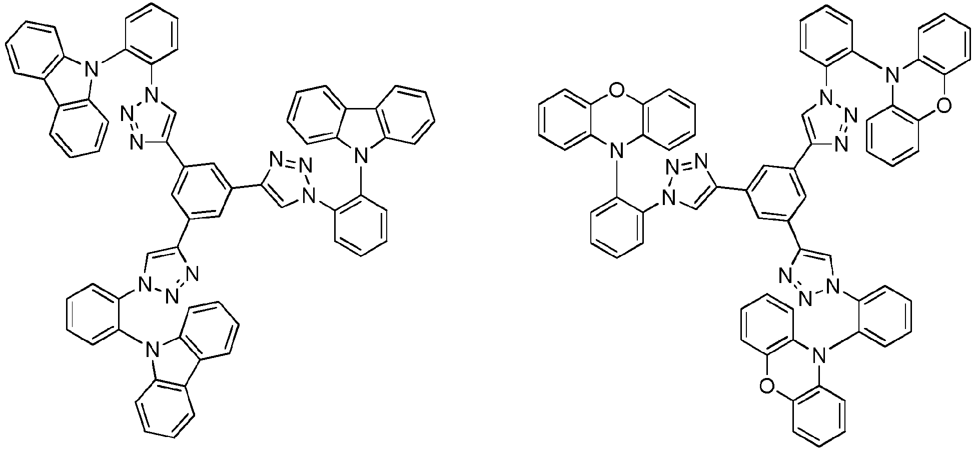

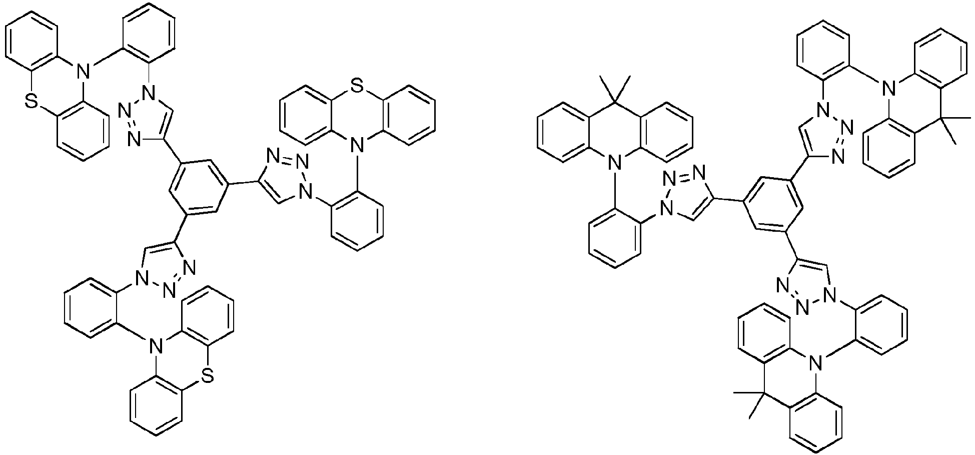

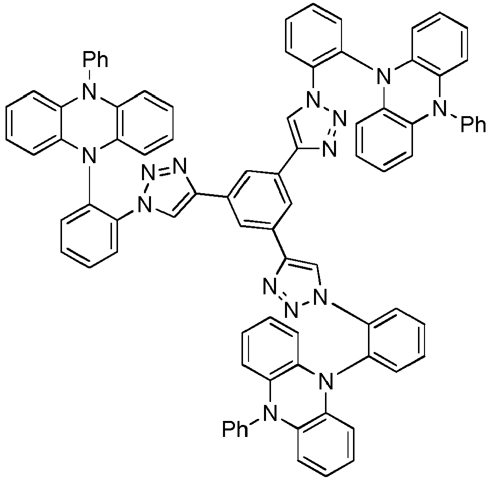

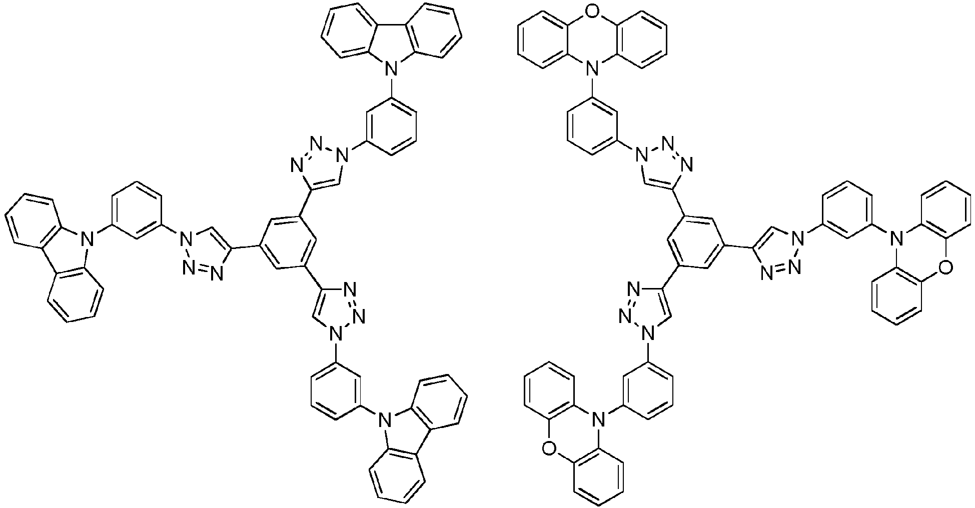

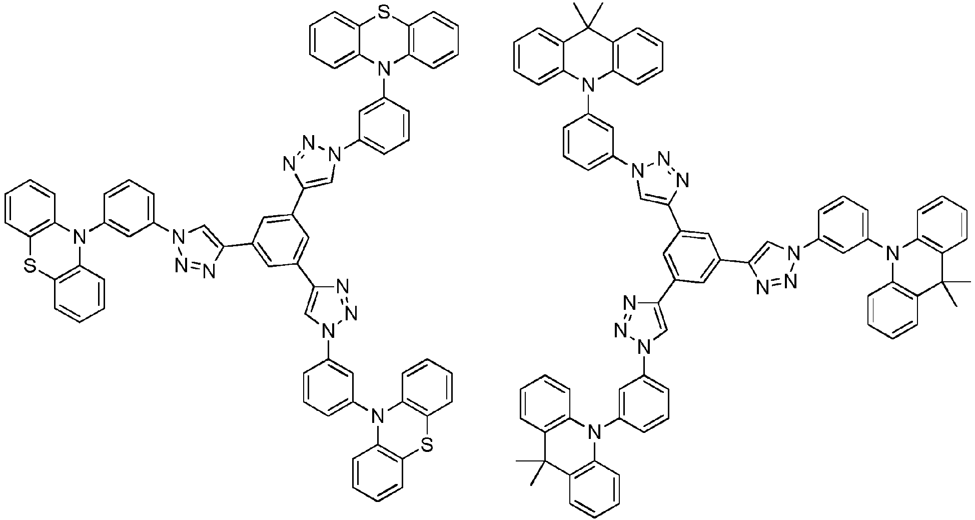

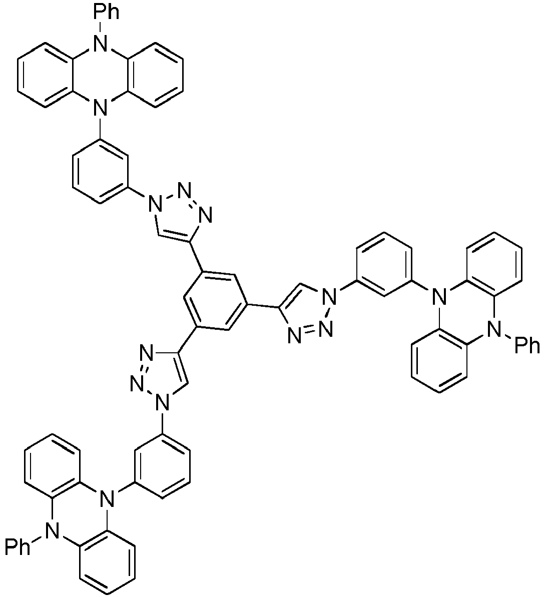

## Patentansprüche

1. Organisches Molekül, aufweisend eine Struktur der Formel 1 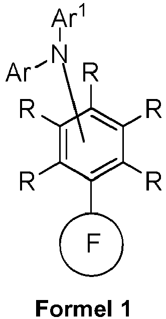 wobei das organische Molekül eine Struktur gemäß der Formel 1* oder Formel 1** aufweist 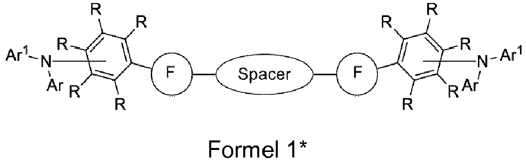 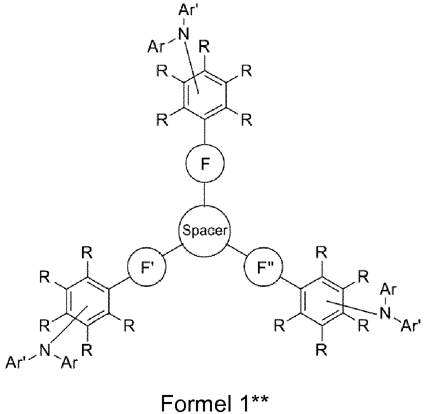 mit F, F' und F" ausgewählt aus der Gruppe bestehend aus 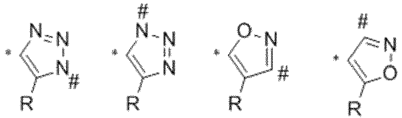 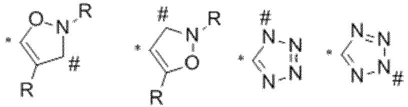 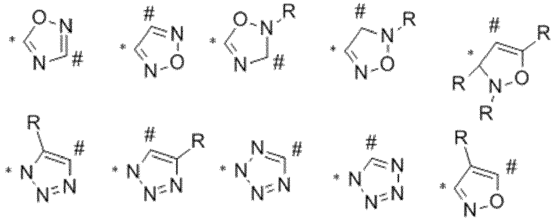 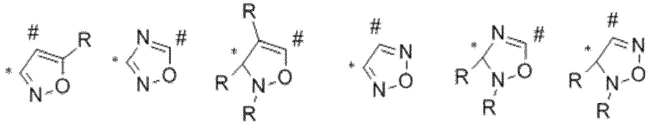
wobei die Verknüpfung zu den benachbarten Einheiten an den mit * und # markierten Stellen stattfindet
und wobei
Spacer ein substituiertes oder unsubstituiertes aromatisches oder heteroaromatisches Ringsystem mit 5 bis 60 aromatischen Ringatomen ist;
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden; R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
NArAr¹ ist ein Donor, der an einer beliebigen Position am Phenylring angebunden sein kann (also in ortho-, meta- oder para-Stellung zur F-Einheit, wobei die jeweils übrigen Substitutionsstellen des Phenylrings mit R substituiert sind), mit Ar, Ar¹ = unabhängig voneinander ein aromatisches oder heteroaromatisches Ringsystem mit 5 - 60 aromatischen Ringatomen, das jeweils durch einen oder mehrere Reste R substituiert sein kann;
wobei Ar und Ar¹ über eine Einheit E miteinander verbunden sind;
E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist;
insbesondere wobei sich die NArAr¹-Einheit und die Einheit F in para-Position zueinander befinden
oder das organische Molekül ausgewählt ist aus der folgenden Gruppe

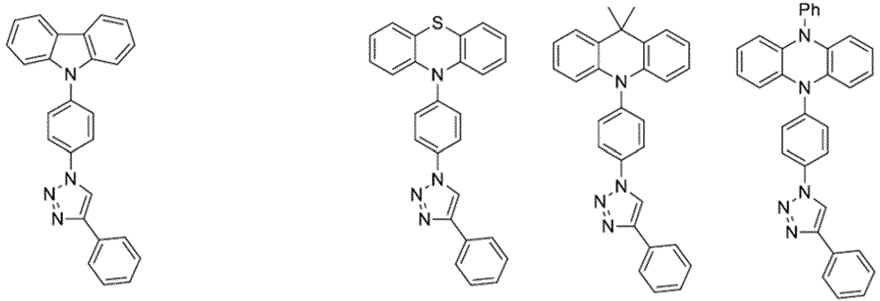

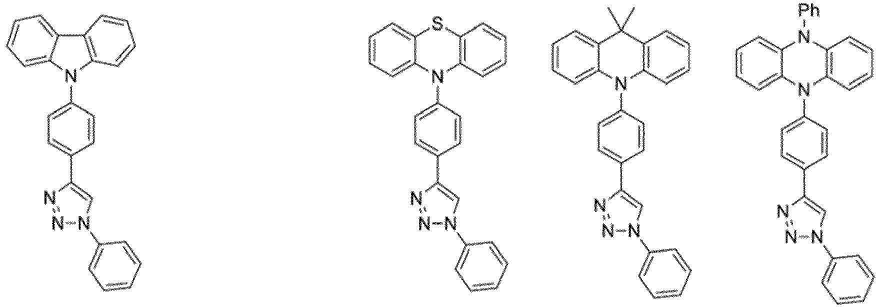

2. Organisches Molekül nach Anspruch 1, aufweisend
- einen ΔE(S₁-T₁)-Wert zwischen dem untersten angeregten Singulett (S₁)- und dem darunter liegenden Triplett (T₁)-Zustand von kleiner als 5000 cm⁻¹, insbesondere von kleiner als 3000 cm⁻¹ aufweist; und/oder
- eine Emissionslebensdauer von höchstens 50 µs.

3. Organisches Molekül nach Anspruch 1 oder 2, wobei der Phenylring, F und/oder NArAr¹ mindestens einen Substituenten zur Erhöhung der Löslichkeit des organischen Moleküls in einem organischen Lösungsmittel aufweisen, wobei der Substituenten zur Erhöhung der Löslichkeit insbesondere ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
- verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

4. Verfahren zur Herstellung eines Organischen Moleküls nach Anspruch 1 bis 3 aufweisend eine [i+j]-Cycloaddition (Clickreaktion)
- einer mit einer NArAr¹-Gruppe versehenen Phenylgruppe, die eine zur Clickreaktion befähigte Gruppe ausgewählt aus einem Dipolarophil und 1,3-Dipol trägt mit
- einer entsprechenden komplementären Gruppe, wobei ein unsubstituierter oder substituierter 5-gliedriger Ring F ausgebildet wird, wobei F, Ar und Ar1 wie in Anspruch 1 definiert sind.

5. Verwendung eines Organischen Moleküls nach Anspruch 1 bis 3 als Emitter oder Absorber in einem optoelektronischen Bauelement.

6. Verwendung nach Anspruch 5, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

7. Optoelektronisches Bauelement, aufweisend ein organisches Molekül nach Anspruch 1 bis 3.

8. Optoelektronisches Bauelement nach Anspruch 7, insbesondere ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

9. Lichtemittierendes Material, aufweisend ein organisches Molekül nach Anspruch 1 bis 3 und ein Hostmaterial, wobei die Triplett (T1)- und Singulett (S1)-Energieniveaus des Hostmaterials energetisch höher liegen als die Triplett (T1)- und Singulett (S1)-Energieniveaus des organischen Moleküls, und wobei das organische Molekül Fluoreszenz oder thermisch aktivierte verzögerte Fluoreszenz emittiert, und einen ΔE(S1-T1)-Wert zwischen dem untersten angeregten Singulett (S1)-Zustand und dem darunter liegenden Triplett (T1)-Zustand von kleiner als 3000 cm⁻¹ aufweist.

10. Verfahren zur Herstellung eines optoelektronischen Bauelements, wobei ein organisches Molekül nach Anspruch 1 bis 3 verwendet wird.

11. Verfahren zur Herstellung eines optoelektronischen Bauelements nach Anspruch 10, wobei ein Organisches Molekül nach Anspruch 1 bis 3 verwendet wird, insbesondere wobei das Organische Molekül auf einen Träger aufgebracht wird, wobei das Aufbringen optional nass-chemisch, mittels kolloidaler Suspension oder mittels Sublimation erfolgt.

12. Verwendung eines Organischen Moleküls nach Anspruch 1 bis 3, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Claims

1. Organic molecule comprising a structure of formula 1 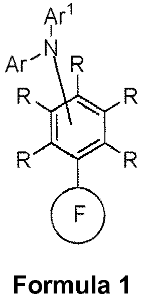 where the organic molecule comprises a structure of formula 1* or formula 1** 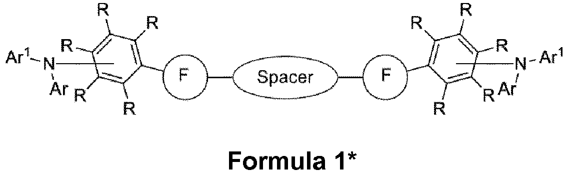 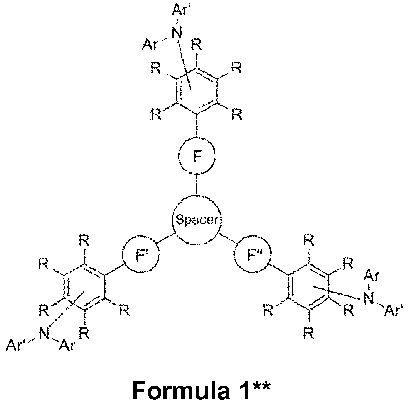 with F, F' and F" selected from the group consisting of 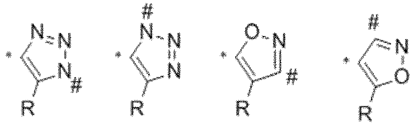 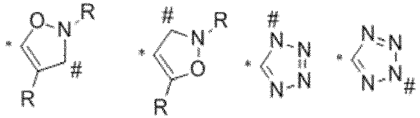 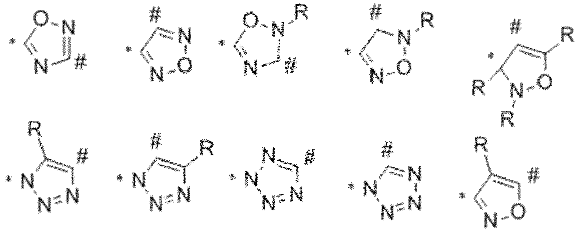 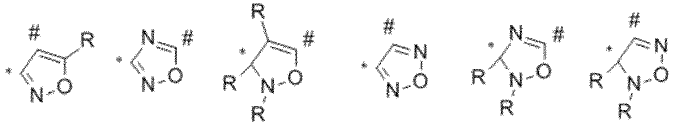
where the linking to the adjacent units takes place at the sites marked with * and #,
and where
Spacer is a substituted or unsubstituted aromatic or heteroaromatic ring system having 5 to 60 aromatic ring atoms;
each R at each instance is identical or different and is H, deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which can in each case be substituted by one or more radicals R², where one or more non-adjacent CH₂ groups can be replaced by R²C=CR², C≡C, Si(R²)₂, Ge(R²)₂, Sn(R²)₂, C=O, C=S, C=Se, C=NR², P(=O)(R²), SO, SO₂, NR², O, S or CONR² and where one or more hydrogen atoms can be replaced by deuterium, F, Cl, Br, I, CN, CF₃ or NO₂, or an aromatic or heteroaromatic ring system having 5 to 60 aromatic ring atoms, which can in each case be substituted by one or more radicals R², or an aryloxy or heteroaryloxy group having 5 to 60 aromatic ring atoms, which can be substituted by one or more radicals R², or a diarylamino group, diheteroarylamino group or arylheteroarylamino group having 10 to 40 aromatic ring atoms, which can be substituted by one or more radicals R², or a combination of these systems; two or more of these substituents R here can also form with each other a mono- or polycyclic, aliphatic, aromatic and/or benzo-fused ring system; R² at each instance is identical or different and is H, deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which can in each case be substituted by one or more radicals R³, where one or more non-adjacent CH₂ groups can be replaced by R³C=CR³, C=C, Si(R³)₂, Ge(R³)₂, Sn(R³)₂, C=O, C=S, C=Se, C=NR³, P(=O)(_{R}³), SO, SO₂, NR³, O, S or CONR³ and where one or more hydrogen atoms can be replaced by deuterium, F, Cl, Br, I, CN, CF₃ or NO₂, or an aromatic or heteroaromatic ring system having 5 to 60 aromatic ring atoms, which can in each case be substituted by one or more radicals R³, or an aryloxy or heteroaryloxy group having 5 to 60 aromatic ring atoms, which can be substituted by one or more radicals R³, or a diarylamino group, diheteroarylamino group or arylheteroarylamino group having 10 to 40 aromatic ring atoms, which can be substituted by one or more radicals R³, or a combination of these systems; two or more of these substituents R² here can also form with each other a mono- or polycyclic, aliphatic, aromatic and/or benzo-fused ring system;
R³ at each instance is identical or different and is H, deuterium, F, CF₃ or an aliphatic, aromatic and/or heteroaromatic hydrocarbon radical having 1 to 20 carbon atoms, in which one or more hydrogen atoms can also be replaced by F or CF₃; two or more substituents R³ here can also form with each other a mono- or polycyclic, aliphatic ring system;
NArAr¹ is a donor which can be attached at any desired position on the phenyl ring (in other words in ortho, meta or para position to the F unit, with each of the remaining substitution sites of the phenyl ring being substituted by R), with Ar, Ar¹ = independently of one another an aromatic or heteroaromatic ring system having 5 - 60 aromatic ring atoms, which can in each case be substituted by one or more radicals R;
where Ar and Ar¹ are linked to each other by a unit E;
E is a covalent single bond or an organic bridge which is a substituted or unsubstituted alkylene, alkenylene, alkynylene or arylene group or a combination of these, or -O-, -NR-, -C=CR₂, - C=NR, -SiR₂-, -S-, -S(O)-, -S(O)₂-, O-interrupted alkyl (unbranched, branched or cyclic), heteroalkyl, aryl, heteroaryl, alkenyl groups, phenyl and substituted phenyl units;
in particular where the NArAr¹ unit and the unit F are in para position to each other,
or the organic molecule is selected from the following group

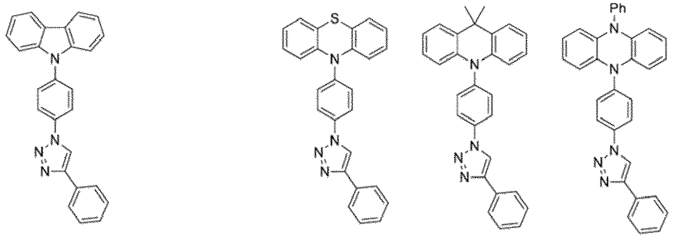

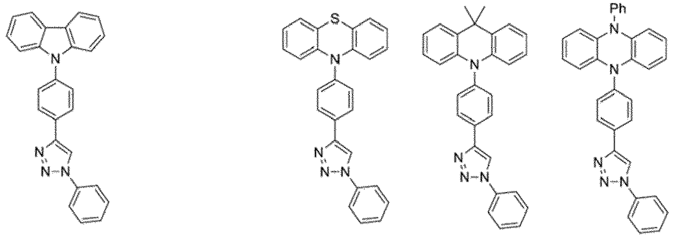

2. Organic molecule according to Claim 1, comprising
- a ΔE(S₁-T₁) value between the lowest excited singlet (S₁) state and the triplet (T₁) state lying therebelow of less than 5000 cm⁻¹, in particular of less than 3000 cm⁻¹; and/or
- an emission lifetime of at most 50 µs.

3. Organic molecule according to Claim 1 or 2, where the phenyl ring, F and/or NArAr¹ comprise at least one substituent for increasing the solubility of the organic molecule in an organic solvent, where the substituent for increasing the solubility is in particular selected from the group consisting of:
- branched or unbranched or cyclic long-chain alkyl chains of a length from C1 to C30,
- branched or unbranched or cyclic long-chain alkoxy chains of a length from C1 to C30,
- branched or unbranched or cyclic long-chain perfluoroalkyl chains of a length from C1 to C30, and
- short-chain polyethers having a chain length of 3-50 repeating units.

4. Method for producing an organic molecule according to Claim 1 to 3, comprising an [i+j] cycloaddition (click reaction) of
- a phenyl group, provided with an NArAr¹ group and bearing a group, capable of a click reaction, selected from a dipolarophile and 1,3-dipole, with
- a corresponding complementary group to form an unsubstituted or substituted 5-membered ring F, where F, Ar and Ar1 are defined as in Claim 1.

5. Use of an organic molecule according to Claim 1 to 3 as emitter or absorber in an optoelectronic component.

6. Use according to Claim 5, where the optoelectronic component is selected from the group consisting of:
- organic light-emitting elements (OLEDs),
- light-emitting electrochemical cells,
- OLED sensors, in particular in gas and vapour sensors that are not hermetically shielded with respect to the outside,
- organic solar cells,
- organic field-effect transistors,
- organic lasers and
- down-conversion elements.

7. Optoelectronic component comprising an organic molecule according to Claim 1 to 3.

8. Optoelectronic component according to Claim 7, in particular formed as a component selected from the group consisting of organic light-emitting component, organic diode, organic solar cell, organic transistor, organic light-emitting diode, light-emitting electrochemical cell, organic field-effect transistor and organic laser.

9. Light-emitting material comprising an organic molecule according to Claim 1 to 3 and a host material, where the triplet (T1) and singlet (S1) energy levels of the host material are at a higher energy than the triplet (T1) and singlet (S1) energy levels of the organic molecule, and where the organic molecule emits fluorescence or thermally activated delayed fluorescence, and has a ΔE(S1-T1) value between the lowest excited singlet (S1) state and the triplet (T1) state lying therebelow of less than 3000 cm⁻¹.

10. Method for producing an optoelectronic component, where an organic molecule according to Claim 1 to 3 is used.

11. Method for producing an optoelectronic component according to Claim 10, where an organic molecule according to Claim 1 to 3 is used, in particular where the organic molecule is applied to a support, where the application is optionally effected wet-chemically, by means of colloidal suspension or by means of sublimation.

12. Use of an organic molecule according to Claim 1 to 3, in particular in an optoelectronic component, for converting UV radiation or blue light into visible light, in particular into green, yellow or red light (down-conversion).

## Revendications

1. Molécule organique, comprenant une structure de la formule 1 : 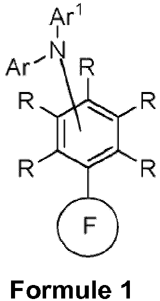 la molécule organique comprenant une structure selon la formule 1* ou la formule 1** : 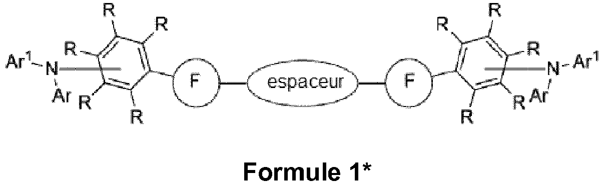 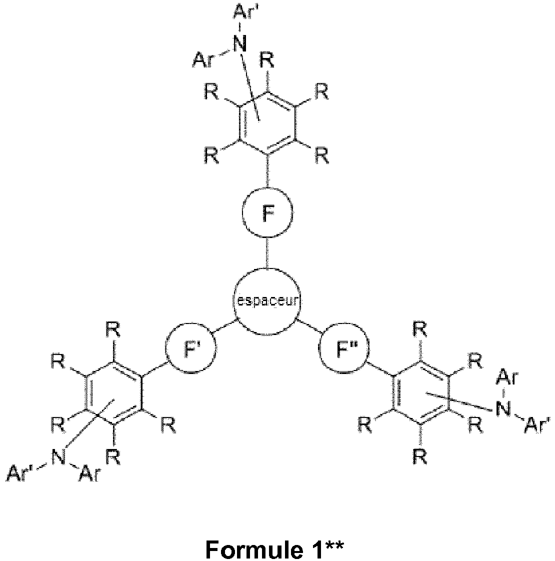 dans lesquelles F, F' et F" sont choisis dans le groupe constitué par : 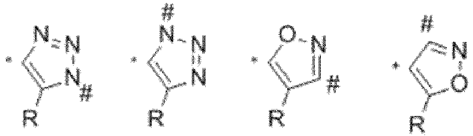 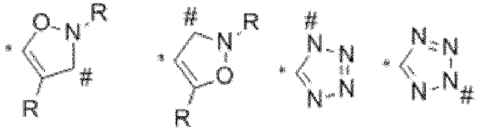 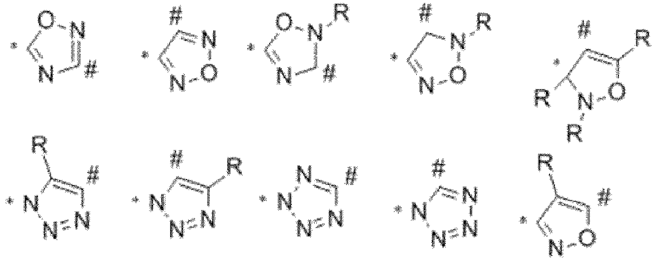 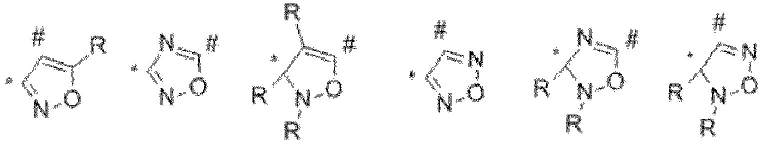
la liaison aux unités voisines ayant lieu aux emplacements marqués avec * et #,
et dans lesquelles
« espaceur » est un système cyclique aromatique ou hétéroaromatique substitué ou non substitué de 5 à 60 atomes de cycle aromatique ;
les R représentent chacun à chaque occurrence, de manière identique ou différente, H, deutérium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R² S(=O)₂R², OSO₂R², un groupe alkyle, alcoxy ou thioalcoxy linéaire de 1 à 40 atomes C, ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui peut à chaque fois être substitué avec un ou plusieurs radicaux R², un ou plusieurs groupes CH₂ non voisins pouvant être remplacés par R²C=CR², C≡C, Si(R²)₂, Ge(R²)₂, Sn(R²)₂, C=O, C=S, C=Se, C=NR², P(=O)(R²), SO, SO₂, NR², O, S ou CONR², et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R², ou un groupe aryloxy ou hétéroaryloxy de 5 à 60 atomes de cycle aromatique, qui peut être substitué par un ou plusieurs radicaux R², ou un groupe diarylamino, un groupe dihétéroarylamino ou un groupe arylhétéroarylamino de 10 à 40 atomes de cycle aromatique, qui peut être substitué par un ou plusieurs radicaux R², ou une combinaison de ces systèmes ; deux ou plus de ces substituants R pouvant également former les uns avec les autres un système cyclique mono- ou polycyclique, aliphatique, aromatique et/ou benzoannelé ; les R² représentant à chaque occurrence, de manière identique ou différente, H, deutérium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, un groupe alkyle, alcoxy ou thioalcoxy linéaire de 1 à 40 atomes C, ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui peut à chaque fois être substitué avec un ou plusieurs radicaux R³, un ou plusieurs groupes CH₂ non voisins pouvant être remplacés par R³C=CR³, C=C, Si(R³)₂, Ge(R³)₂, Sn(R³)₂, C=O, C=S, C=Se, C=NR³, P(=O)(R³), SO, SO₂, NR³, O, S ou CONR³, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R³, ou un groupe aryloxy ou hétéroaryloxy de 5 à 60 atomes de cycle aromatique, qui peut être substitué par un ou plusieurs radicaux R³, ou un groupe diarylamino, un groupe dihétéroarylamino ou un groupe arylhétéroarylamino de 10 à 40 atomes de cycle aromatique, qui peut être substitué par un ou plusieurs radicaux R³, ou une combinaison de ces systèmes ; deux ou plus de ces substituants R² pouvant également former les uns avec les autres un système cyclique mono- ou polycyclique, aliphatique, aromatique et/ou benzoannelé;
les R³ représentant à chaque occurrence, de manière identique ou différente, H, deutérium, F, CF₃ ou un radical hydrocarboné aliphatique, aromatique et/ou hétéroaromatique de 1 à 20 atomes C, dans lequel un ou plusieurs atomes H peuvent également être remplacés par F ou CF₃; deux substituants R³ ou plus pouvant également former les uns avec les autres un système cyclique aliphatique mono- ou polycyclique ;
NArAr¹ est un donneur, qui peut être relié à une position quelconque sur le cycle phényle (c.-à-d. en position ortho, méta ou para par rapport à l'unité F, les emplacements de substitution restants du cycle phényle étant chacun substitués avec R), avec Ar, Ar¹ = indépendamment l'un de l'autre un système cyclique aromatique ou hétéroaromatique de 5 à 60 atomes de cycle aromatique, qui peut à chaque fois être substitué par un ou plusieurs radicaux R ;
Ar et Ar¹ étant reliés l'un avec l'autre par une unité E ;
E représentant une simple liaison covalente ou un pont organique, qui est un groupe alkylène, alcénylène, alcynylène ou arylène substitué ou non substitué, ou une combinaison de ceux-ci, ou -O-, -NR-, -C=CR₂-, -C=NR, -SiR₂-, -S-, -S(O)-, -S(O)₂-, des groupes alkyle (non ramifiés, ramifiés ou cycliques), hétéroalkyle, aryle, hétéroaryle, alcényle interrompus par O, des unités phényle et phényle substituées ;
l'unité NArAr¹ et l'unité F se trouvant notamment en position para l'une par rapport à l'autre,
ou la molécule organique étant choisie dans le groupe suivant :

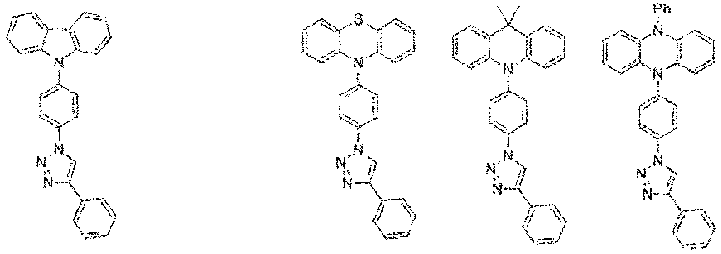

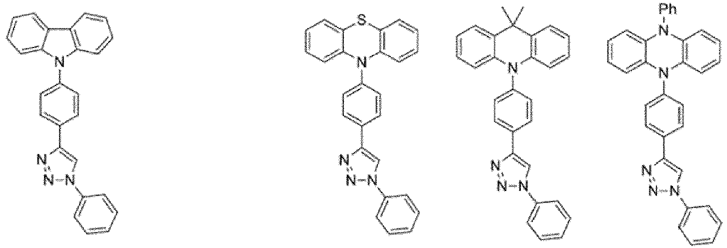

2. Molécule organique selon la revendication 1, présentant :
- a une valeur ΔE(S₁-T₁) entre l'état singulet excité le plus inférieur (S₁) et l'état triplet sous-jacent (T₁) de moins de 5 000 cm⁻¹, notamment de moins de 3 000 cm⁻¹ ; et/ou
- une durée de vie d'émission d'au plus 50 µs.

3. Molécule organique selon la revendication 1 ou 2, dans laquelle le cycle phényle, F et/ou NArAr¹ comprennent au moins un substituant destiné à augmenter la solubilité de la molécule organique dans un solvant organique, les substituants destinés à augmenter la solubilité étant notamment choisis dans le groupe constitué par :
- les chaînes alkyle à chaîne longue ramifiées ou non ramifiées ou cycliques d'une longueur de C1 à C30,
- les chaînes alcoxy à chaîne longue ramifiées ou non ramifiées ou cycliques d'une longueur de C1 à C30,
- les chaînes perfluoroalkyle à chaîne longue ramifiées ou non ramifiées ou cycliques d'une longueur de C1 à C30, et
- les polyéthers à chaîne courte d'une longueur de chaîne de 3 à 50 unités de répétition.

4. Procédé de fabrication d'une molécule organique selon les revendications 1 à 3, comprenant une cycloaddition [i+j] (réaction clic)
- d'un groupe phényle muni d'un groupe NArAr¹, qui porte un groupe apte à la réaction clic choisi parmi un dipolarophile et un 1,3-dipol, avec
- un groupe complémentaire correspondant, un cycle F à 5 chaînons non substitué ou substitué étant formé, F, Ar et Ar¹ étant tels que définis dans la revendication 1.

5. Utilisation d'une molécule organique selon les revendications 1 à 3 en tant qu'émetteur ou absorbeur dans un composant optoélectronique.

6. Utilisation selon la revendication 5, dans laquelle le composant optoélectronique est choisi dans le groupe constitué par :
- les composants électroluminescents organiques (OLED),
- les cellules électrochimiques électroluminescentes,
- les capteurs OLED, notamment dans des capteurs de gaz et de vapeur non blindés hermétiquement vers l'extérieur,
- les cellules solaires organiques,
- les transistors à effet de champ organiques,
- les lasers organiques et
- les éléments de conversion à la baisse.

7. Composant optoélectronique, comprenant une molécule organique selon les revendications 1 à 3.

8. Composant optoélectronique selon la revendication 7, notamment configuré sous la forme d'un composant choisi dans le groupe constitué par un composant électroluminescent organique, une diode organique, une cellule solaire organique, un transistor organique, une diode électroluminescente organique, une cellule électrochimique électroluminescente, un transistor à effet de champ organique et un laser organique.

9. Matériau électroluminescent, comprenant une molécule organique selon les revendications 1 à 3 et un matériau hôte, les niveaux d'énergie triplet (T1) et singulet (S1) du matériau hôte étant énergétiquement plus élevés que les niveaux d'énergie triplet (T1) et singulet (S1) de la molécule organique, et la molécule organique émettant une fluorescence ou une fluorescence retardée activée thermiquement, et présentant une valeur ΔE(S1-T1) entre l'état singulet excité le plus inférieur (S1) et l'état triplet sous-jacent (T1) de moins de 3 000 cm⁻¹.

10. Procédé de fabrication d'un composant optoélectronique, dans lequel une molécule organique selon les revendications 1 à 3 est utilisée.

11. Procédé de fabrication d'un composant optoélectronique selon la revendication 10, dans lequel une molécule organique selon les revendications 1 à 3 est utilisée, notamment dans lequel la molécule organique est appliquée sur un support, l'application ayant éventuellement lieu par voie chimique humide, au moyen d'une suspension colloïdale ou par sublimation.

12. Utilisation d'une molécule organique selon les revendications 1 à 3, notamment dans un composant optoélectronique, pour la conversion d'un rayonnement UV ou d'une lumière bleue en lumière visible, notamment en lumière verte, jaune ou rouge (conversion à la baisse).
